# DEMANDE DE BREVET EUROPEEN

(11) **EP 4 778 693 A1**
(43) Date de publication de la demande: **22.07.2026**
(21) Numéro de dépôt: 26151497.0
(22) Date de dépôt: 13.01.2026
(51) Int. Cl.: B29B 17/02, H10F 19/85, B29L 9/00, B32B 43/00

(54) **PROCÉDÉ DE DÉLAMINATION D'UNE FEUILLE ARRIÈRE DE MODULE PHOTOVOLTAÏQUE**

(30) Priorité: 15.01.2025 FR 2500435
(71) Demandeur: Commissariat à l'Energie Atomique et aux Energies Alternatives, 75015 Paris (FR)
(72) Inventeur: AUGER, Aurélien, 38054 Grenoble cedex 09 (FR); LANDA, Margot, 38054 Grenoble cedex 09 (FR)
(74) Mandataire: Ipsilon

(57) **Abrégé**

L'invention concerne un procédé de délamination d'une feuille arrière multicouche de module photovoltaïque, comprenant au moins les étapes consistant à :
a) Disposer d'au moins une feuille arrière multicouche de module photovoltaïque,
la feuille arrière comportant :
- au moins une couche fluorée comprenant au moins un polymère fluoré et
- au moins une couche, dite couche intermédiaire, comprenant au moins un polymère choisi parmi le polytéréphtalate d'éthylène (PET), le polytéréphtalate de triméthylène (PTT), le polytéréphtalate de butylène (PBT), le polynaphtalate d'éthylène (PEN), les polyéthercétones (PEK), les polyaryléthercétones (PAEK), les polyétherimides (PEI) et leurs mélanges ;

b) Délaminer ladite feuille arrière au contact d'au moins un solvant eutectique profond, dit DES.

## Description

### Domaine technique

La présente invention se rapporte au recyclage de modules photovoltaïques, encore appelés panneaux photovoltaïques, et plus particulièrement au recyclage du matériau constitutif des feuilles arrières (dites *« backsheet »* selon la terminologie anglo-saxonne), encore appelées feuilles de fond, présentes dans les modules photovoltaïques. Plus précisément, elle concerne la séparation des différentes couches formant une telle feuille arrière de module photovoltaïque pour permettre le recyclage et/ou la réutilisation de ses composants.

### Technique antérieure

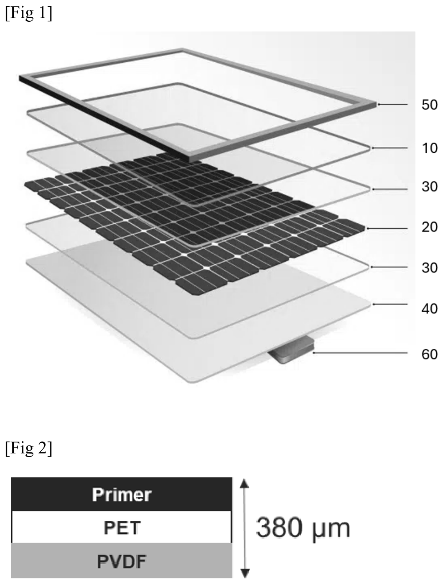

Comme représenté en figure 1 illustrant un exemple de module photovoltaïque, un module photovoltaïque est généralement formé d'un empilement comportant une plaque de verre 10, des cellules photovoltaïques 20 prises en sandwich entre deux couches d'encapsulant à base d'EVA 30 et une feuille arrière 40, d'un cadre en aluminium 50 pour maintenir l'empilement, et d'une boite de jonction 60.

La feuille arrière 40 joue un rôle de protection du module photovoltaïque, principalement contre les contraintes environnementales telles que l'humidité et la poussière, ainsi qu'un rôle d'isolation électrique et de support mécanique. Elle permet également de bloquer les rayonnements UV. Elle comporte généralement une couche d'apprêt, dite primer, une couche intermédiaire, et une couche extérieure. La couche d'apprêt, par exemple à base de polyoléfines, vise principalement à assurer l'adhésivité de la feuille arrière au reste du module photovoltaïque. La couche intermédiaire, généralement à base de polytéréphtalate d'éthylène (PET), permet notamment d'assurer la stabilité mécanique de la feuille arrière, avec de préférence une bonne stabilité thermique. Enfin, la couche extérieure, généralement à base de polymère fluoré, vise à protéger le module photovoltaïque des agressions extérieures telles que l'oxydation et l'humidité, et ainsi à augmenter la durée de vie du module photovoltaïque.

Afin de fournir une production d'énergie alternative pérenne et décarbonée, l'amélioration des techniques de recyclage de ces modules photovoltaïques relève d'un objectif constant, notamment au regard de l'empreinte environnementale d'un module photovoltaïque et des matériaux critiques qu'il contient. A ce titre, la législation européenne a récemment évolué. Les techniques de recyclage actuellement mises en place concernent essentiellement la récupération du cadre en aluminium, des câbles de cuivre, de la boîte de jonction et du verre. Elles permettent d'atteindre un taux de recyclabilité supérieur à 90% en masse. Toutefois, ces techniques de recyclage ne permettent pas de récupérer, de façon satisfaisante, les matériaux à valeur marchande élevée, les matériaux critiques, les matériaux toxiques et/ou les matériaux à empreinte environnementale élevée.

Par conséquent, il est recherché des solutions pour récupérer les matériaux critiques, tels que l'argent, le silicium, le cuivre ou l'indium, et pour isoler les matériaux toxiques, tels que les polymères fluorés contenus dans les feuilles arrières de modules photovoltaïques.

Des voies sont en cours de développement pour séparer la feuille arrière du reste du module photovoltaïque afin de pouvoir la traiter indépendamment.

Morita *et al.* [1] décrit l'hydrolyse alcaline d'une feuille arrière contenant du PET et du PVDF pour le recyclage du PVDF.

Rubino *et al.* [2] décrit la valorisation de fractions polymériques et de métaux issus de panneaux photovoltaïques en fin de vie, mettant en œuvre du cyclohexane.

Camargo *et al.* [3] décrit le recyclage de modules photovoltaïques notamment par mise en œuvre d'un traitement thermique pour dégrader les polymères.

Ces procédés présentent toutefois l'inconvénient de mettre en œuvre des produits dangereux, nocifs pour l'environnement et/ou des conditions extrêmes.

De plus, à la connaissance des inventeurs, aucune solution efficace n'a été identifiée jusqu'à présent pour recycler et/ou réutiliser les matériaux constitutifs d'une feuille arrière de module photovoltaïque, sans compromettre leur intégrité.

Ainsi, il existe un besoin pour un procédé qui soit de mise en œuvre simple, rapide et peu coûteuse et présentant un faible impact environnemental, afin de récupérer les différentes couches d'une feuille arrière de module photovoltaïque séparées les unes des autres, en vue de recycler et/ou de réutiliser les matériaux constitutifs de ladite feuille arrière, notamment pour la fabrication d'une nouvelle feuille arrière de module photovoltaïque. En particulier, il existe un besoin pour un procédé qui permette de récupérer les différentes couches d'une feuille arrière de module photovoltaïque sans résidus issus des matériaux adjacents.

### Exposé de l'invention

L'invention vise à satisfaire au moins partiellement ces besoins.

Ainsi, l'invention concerne un procédé de délamination d'une feuille arrière multicouche de module photovoltaïque, comprenant au moins les étapes consistant à :
a) Disposer d'au moins une feuille arrière multicouche de module photovoltaïque,
   la feuille arrière comportant :
   - au moins une couche fluorée comprenant au moins un polymère fluoré, et
   - au moins une couche, dite couche intermédiaire, comprenant au moins un polymère choisi parmi le polytéréphtalate d'éthylène (PET), le polytéréphtalate de triméthylène (PTT), le polytéréphtalate de butylène (PBT), le polynaphtalate d'éthylène (PEN), les polyéthercétones (PEK), les polyaryléthercétones (PAEK), les polyétherimides (PEI) et leurs mélanges ;
b) Délaminer ladite feuille arrière au contact d'au moins un solvant eutectique profond, dit DES.

Au sens de l'invention, la délamination qualifie la désolidarisation les unes des autres d'au moins deux couches, en particulier de toutes les couches, constituant la feuille arrière.

Au sens de l'invention, par feuille arrière « multicouche », on entend désigner une feuille arrière comportant au moins deux couches.

En particulier, la feuille arrière comporte en outre au moins une couche d'apprêt polymérique.

A la connaissance des inventeurs, il n'a jamais été proposé de désolidariser les différentes couches d'une feuille arrière les unes des autres avec un DES.

Comme il ressort des exemples ci-après, la mise en contact d'une feuille arrière avec différents solvants eutectiques profonds, à base de chlorure de choline et d'urée, à base de thymol et d'acide décanoïque, ou à base de thymol et d'acide lactique, permet avantageusement de délaminer une feuille arrière pour obtenir les couches de la feuille arrière désolidarisées les unes des autres. Il a été montré que les couches obtenues comportent très peu, voire pas d'impuretés issues des autres couches de la feuille arrière. Il a en outre été vérifié que les propriétés mécaniques des différentes couches sont peu voire pas dégradées.

Par exemple, la ou les couches intermédiaires obtenues à l'issue de la délamination de la feuille arrière au contact d'un DES comportent peu, voire sont exemptes de polymère fluoré. Les polymères qui forment ces couches peuvent ainsi être recyclés et/ou réutilisés, avec peu de contamination, voire sans contamination par des polymères fluorés, tandis que les polymères fluorés peuvent être récupérés indépendamment.

Ainsi, l'invention concerne également l'utilisation du procédé de délamination selon l'invention pour le recyclage des matériaux constitutifs d'une feuille arrière multicouche de module photovoltaïque, notamment telle que décrite ci-après.

Dans le cadre de l'invention, on entend par :
- « C_{t-z} » où t et z sont des entiers, une chaîne carbonée pouvant avoir de t à z atomes de carbone ; par exemple C₁₋₄ une chaîne carbonée qui peut avoir de 1 à 4 atomes de carbone ;
- « groupement hydrocarboné », un radical saturé ou non, linéaire, ramifié ou cyclique, aromatique ou non, comprenant du carbone et de l'hydrogène ;
- « chaîne aliphatique », un groupe hydrocarboné constitué exclusivement d'atomes de carbone et d'hydrogène, linéaire ou ramifié, saturé ou insaturé, non aromatique. De préférence, une chaîne aliphatique est une chaîne alkyle ;
- « alkyle », un groupe aliphatique saturé, linéaire ou ramifié ; par exemple un groupe C₁₋₄-alkyle représente une chaîne carbonée de 1 à 4 atomes de carbone, linéaire ou ramifiée, plus particulièrement un méthyle, éthyle, propyle, isopropyle, butyle, isobutyle, tert-butyle ;
- « alcényle », un groupe aliphatique mono- ou poly-insaturé, linéaire ou ramifié ;
- « alkylène », un radical divalent saturé, linéaire ou ramifié, dérivé d'un alkyle. Par exemple un groupe C₁-C₃-alkylène représente une chaine carbonée saturée, linéaire ou ramifiée, de 1 à 3 atomes de carbone, par exemple un méthylène, éthylène, 1-méthyléthylène ou propylène ;
- « groupe fonctionnel oxygéné » un groupe fonctionnel comprenant au moins un atome d'oxygène, en particulier un groupe fonctionnel constitué exclusivement d'atomes d'oxygène et optionnellement d'atomes de carbone et/ou d'hydrogène, par exemple un groupe hydroxyle, un groupe carbonyle, un groupe ester ou un groupe éther.

D'autres caractéristiques, variantes et avantages des objets de l'invention, ressortiront mieux à la lecture de la description, des exemples et figures qui vont suivre, donnés à titre illustratif et non limitatif de l'invention.

Dans la suite du texte, les expressions « compris entre ... et ... », « allant de ... à ... » et « variant de ... à ... » sont équivalentes et entendent signifier que les bornes sont incluses, sauf mention contraire.

Par soucis de clarté des dessins, les proportions des différents éléments constitutifs des empilements multicouches ne sont pas représentées à l'échelle.

### Brève description des dessins

[Fig 1] représente schématiquement selon une vue éclatée un exemple de module photovoltaïque, dans lequel les différents éléments sont séparés les uns des autres par soucis de visibilité.
[Fig 2] représente schématiquement un exemple de feuille arrière telle que mise en œuvre en exemple.
[Fig 3] représente le spectre FTIR-ATR de la feuille arrière mise en œuvre en exemple 1 avant son traitement, du côté de la couche de primer en PE (face interne) et du côté de la couche fluorée en PVDF (face externe).
[Fig 4] représente le spectre FTIR-ATR de la couche de primer récupérée à l'issue du traitement pour l'essai B de l'exemple 1.
[Fig 5] représente le spectre FTIR-ATR de la couche intermédiaire en PET récupérée à l'issue du traitement pour l'essai B de l'exemple 1.
[Fig 6] représente le spectre FTIR-ATR de la couche fluorée en PVDF récupérée à l'issue du traitement pour l'essai B de l'exemple 1.
[Fig 7] représente les courbes obtenues par DSC pour la feuille arrière mise en œuvre en exemple 1 avant son traitement (a), et pour la couche de primer (b), la couche intermédiaire en PET (c) et la couche fluorée en PVDF (d) récupérées à l'issue du traitement pour l'essai B de l'exemple 1.
[Fig 8] représente le spectre FTIR-ATR de la feuille arrière mise en œuvre en exemple 2 avant son traitement, du côté de la couche fluorée en PVDF (face externe).
[Fig 9] représente le spectre FTIR-ATR de la feuille arrière mise en œuvre en exemple 2 avant son traitement du côté de la couche de primer en PE (face interne).
[Fig 10] représente la courbe obtenue par DSC pour la feuille arrière mise en œuvre en exemple 2 avant son traitement.
[Fig 11] représente le spectre FTIR-ATR de la couche de primer récupérée à l'issue du traitement de l'exemple 2.1.
[Fig 12] représente la courbe obtenue par DSC pour la couche de primer récupérées à l'issue du traitement de l'exemple 2.1.
[Fig 13] représente le spectre FTIR-ATR de la couche intermédiaire en PET récupérée à l'issue du traitement de l'exemple 2.1 (haut) et pour un PET commercial (bas).
[Fig 14] représente la courbe obtenue par DSC pour la couche intermédiaire en PET récupérée à l'issue du traitement de l'exemple 2.1.
[Fig 15] représente le spectre FTIR-ATR de la couche fluorée en PVDF récupérée à l'issue du traitement de l'exemple 2.1 (haut) et pour un PVDF commercial (bas).
[Fig 16] représente la courbe obtenue par DSC pour la couche fluorée récupérées à l'issue du traitement de l'exemple 2.1.
[Fig 17] représente le spectre FTIR-ATR de la couche de primer en PE récupérée à l'issue du traitement de l'exemple 2.2.
[Fig 18] représente le spectre FTIR-ATR de la couche intermédiaire en PET récupérée à l'issue du traitement de l'exemple 2.2.
[Fig 19] représente le spectre FTIR-ATR de la couche fluorée en PVDF récupérée à l'issue du traitement de l'exemple 2.2.
[Fig 20] représente le spectre FTIR-ATR de la feuille arrière mise en œuvre en exemple 3 avant son traitement (haut), du côté de la couche de couche fluorée en PVDF (face externe) et d'un PVDF commercial (bas).
[Fig 21] représente le spectre FTIR-ATR de la feuille arrière mise en œuvre en exemple 3 avant son traitement (haut) du côté de la primer en PE (face interne) et d'un PE commercial (bas).
[Fig 22] représente la courbe obtenue par DSC pour la feuille arrière mise en œuvre en exemple 3 avant son traitement.
[Fig 23] représente le spectre FTIR-ATR de la couche fluorée en PVDF récupérée à l'issue du traitement de l'exemple 3 (haut) et d'un PVDF commercial (bas).
[Fig 24] représente la courbe obtenue par DSC pour la couche fluorée en PVDF récupérée à l'issue du traitement de l'exemple 3.
[Fig 25] représente le spectre FTIR-ATR de la couche de primer en PE récupérée à l'issue du traitement de l'exemple 3 (haut) et pour un PE commercial (bas).
[Fig 26] représente la courbe obtenue par DSC pour la couche de primer en PE récupérée à l'issue du traitement de l'exemple 3.
[Fig 27] représente le spectre FTIR-ATR de la couche intermédiaire en PET récupérée à l'issue du traitement de l'exemple 3.
[Fig 28] représente la courbe obtenue par DSC pour la couche intermédiaire en PET récupérée à l'issue du traitement de l'exemple 3.
[Fig 29] représente des photographies de l'échantillon mis en œuvre en exemple 3 avant le traitement (à gauche), lors de l'immersion dans le DES (milieu) et après désolidarisation des différentes couches (à droite).
[Fig 30] représente le spectre FTIR-ATR de la première couche fluorée en PVDF récupérée à l'issue du traitement de l'exemple 4.
[Fig 31] représente la courbe obtenue par DSC pour la première couche fluorée en PVDF récupérée à l'issue du traitement de l'exemple 4.
[Fig 32] représente le spectre FTIR-ATR de la couche intermédiaire en PET récupérée à l'issue du traitement de l'exemple 4.
[Fig 33] représente la courbe obtenue par DSC pour la couche intermédiaire en PET récupérée à l'issue du traitement de l'exemple 4.
[Fig 34] représente le spectre FTIR-ATR de la seconde couche fluorée en PVDF récupérée à l'issue du traitement de l'exemple 4 sur ses deux faces opposées.
[Fig 35] représente la courbe obtenue par DSC pour la seconde couche fluorée en PVDF récupérée à l'issue du traitement de l'exemple 4.

### Description détaillée

### Feuille arrière

L'étape a) du procédé de délamination consiste à disposer d'une feuille arrière de module photovoltaïque. En particulier, à l'étape a), la feuille arrière peut être dissociée du reste du module photovoltaïque.

La feuille arrière comporte au moins une couche fluorée et au moins une couche intermédiaire. Il est entendu que la couche fluorée et la couche intermédiaire sont solidaires l'une de l'autre, en particulier empilées l'une sur l'autre.

Une face de la couche fluorée peut adhérer à tout ou partie d'une face de la couche intermédiaire, optionnellement par l'intermédiaire d'un adhésif.

Une face de ladite couche fluorée peut être en contact avec tout ou partie d'une face de ladite couche intermédiaire.

La couche fluorée et la couche intermédiaire peuvent aussi prendre en sandwich une couche additionnelle, en particulier au moins une couche d'adhésif et/ou une couche en un métal, notamment en aluminium.

La couche fluorée comprend au moins un polymère fluoré. Au sens de l'invention, on entend désigner par « polymère fluoré » un polymère formé à partir d'au moins un monomère comportant au moins un atome de fluor.

Le polymère fluoré peut être choisi parmi les homopolymères et les copolymères formés à partir d'au moins un monomère choisi parmi le fluorure de vinyle, le fluorure de vinylidène et le tétrafluoroéthylène dont l'un des atomes de fluor peut être remplacé par un atome de chlore ou un groupement CF₃, et leurs mélanges. En particulier, le polymère fluoré peut être choisi parmi le polyfluorure de vinyle (PVF), le polyfluorure de vinylidène (PVDF), le polytétrafluoroéthylène (PTFE), le copolymère de fluoroéthylène et d'éther vinylique (FEVE), le copolymère de tétrafluoroéthylène, d'hexafluoropropylène et de fluorure de vinylidène (THV), le poly(éthylène-co-tétrafluoroéthylène) (ETFE), le poly(ethylène-co-chlorotrifluoroéthylène) (ECTFE) et leurs mélanges.

De préférence, le polymère fluoré est choisi parmi le polyfluorure de vinyle (PVF), le polyfluorure de vinylidène (PVDF) et leur mélange, notamment le polymère fluoré est le polyfluorure de vinylidène (PVDF).

En particulier, la couche fluorée peut être dénuée de polymères non fluorés.

La couche fluorée peut comprendre en outre au moins une charge minérale, notamment de l'oxyde de titane (TiO₂).

La couche fluorée peut comprendre, par rapport à sa masse totale, au moins 80% en masse, en particulier au moins 90% en masse, plus particulièrement au moins 95% en masse, notamment au moins 99% en masse du ou des polymères fluorés, notamment tels que décrits précédemment, voire peut être constituée du ou des polymères fluorés, notamment tels que décrits précédemment.

La couche intermédiaire comprend au moins un polymère choisi parmi le polytéréphtalate d'éthylène (PET), le polytéréphtalate de triméthylène (PTT), le polytéréphtalate de butylène (PBT), le polynaphtalate d'éthylène (PEN), les polyéthercétones (PEK), les polyaryléthercétones (PAEK), les polyétherimides (PEI) et leurs mélanges.

En particulier, la couche intermédiaire peut comprendre au moins un polymère choisi parmi le polytéréphtalate d'éthylène (PET), le polytéréphtalate de triméthylène (PTT), le polytéréphtalate de butylène (PBT) et leurs mélanges, en particulier parmi le polytéréphtalate d'éthylène (PET), le polytéréphtalate de butylène (PBT) et leur mélange. Plus particulièrement, la couche intermédiaire peut comprendre au moins le polytéréphtalate d'éthylène (PET). En particulier, la couche intermédiaire peut être dénuée de polymères distincts du PET, du PTT, du PBT, du PEN, des PEK, des PAEK et/ou des PEI.

La couche intermédiaire peut comprendre, par rapport à sa masse totale, au moins 80% en masse, en particulier au moins 90% en masse, plus particulièrement au moins 95% en masse, notamment au moins 99% en masse d'un ou plusieurs polymères choisis parmi le PET, le PTT et le PBT, notamment de PET, voire peut être constituée d'un ou plusieurs polymères choisis parmi le PET, le PTT et le PBT, notamment de PET.

De préférence, la feuille arrière comporte en outre au moins une couche d'apprêt polymérique, encore appelée couche d'apprêt. Par « couche polymérique », on entend désigner une couche comprenant au moins un polymère.

Dans le cas où la feuille arrière comporte au moins une couche d'apprêt, il est entendu que la couche d'apprêt, la couche intermédiaire et la couche fluorée sont solidaires les unes des autres, en particulier empilées l'une sur l'autre.

En particulier, la couche intermédiaire est prise en sandwich entre la couche fluorée et la couche d'apprêt.

Une face de la couche d'apprêt peut adhérer avec tout ou partie d'une face de la couche intermédiaire, optionnellement par l'intermédiaire d'un adhésif.

Une face de ladite couche d'apprêt peut être en contact avec tout ou partie d'une face de ladite couche intermédiaire.

La couche d'apprêt et la couche intermédiaire peuvent aussi prendre en sandwich une couche additionnelle, notamment au moins une couche d'adhésif.

En particulier, la couche d'apprêt peut comprendre au moins un polymère choisi parmi les polyoléfines, l'éthylène-acétate de vinyle, les copolymères d'éthylène-propylène-diène (EPDM), le polyfluorure de vinyle (PVF), le polyfluorure de vinylidène (PVDF) et leurs mélanges, plus particulièrement parmi les polyoléfines, le polyfluorure de vinyle (PVF), le polyfluorure de vinylidène (PVDF) et leurs mélanges, notamment parmi les polyoléfines. Plus particulièrement, la couche d'apprêt peut comprendre au moins le polyéthylène (PE). En particulier, la couche d'apprêt peut être dénuée de polymères distincts d'une polyoléfine, d'un éthylène-acétate de vinyle, de copolymères d'éthylène-propylène-diène (EPDM), de polyfluorure de vinyle (PVF) et/ou de polyfluorure de vinylidène (PVDF).

La couche d'apprêt peut comprendre, par rapport à sa masse totale, au moins 80% en masse, en particulier au moins 90% en masse, plus particulièrement au moins 95% en masse, notamment au moins 99% en masse d'un ou plusieurs polymères choisis parmi les polyoléfines, l'éthylène-acétate de vinyle, les copolymères d'éthylène-propylène-diène (EPDM), le polyfluorure de vinyle (PVF) et le polyfluorure de vinylidène (PVDF), notamment parmi les polyoléfines, voire peut être constituée d'un ou plusieurs polymères choisis parmi les polyoléfines, l'éthylène-acétate de vinyle, les copolymères d'éthylène-propylène-diène (EPDM), le polyfluorure de vinyle (PVF), le polyfluorure de vinylidène (PVDF), notamment parmi les polyoléfines, par exemple de PE.

La feuille arrière peut présenter une épaisseur allant de 50 µm à 1000 µm, en particulier de 100 µm à 500 µm. La feuille arrière peut présenter une surface supérieure ou égale à 0,5 cm², en particulier supérieure ou égale à 1 cm², notamment comprise entre 3 cm² et 1000 cm², voire entre 5cm² et 500 cm², par exemple entre 5 cm² et 100 cm².

La feuille arrière peut comporter de 2 à 6 couches, en particulier 3 couches.

La feuille arrière peut comporter une succession de couches superposées les unes aux autres, en particulier jointives, dans l'ordre suivant : la couche fluorée, la couche intermédiaire et une couche d'apprêt telle que décrite précédemment.

La feuille arrière peut aussi comporter une succession de couches superposées les unes aux autres, en particulier jointives, dans l'ordre suivant : la couche fluorée, une couche d'aluminium, la couche intermédiaire et une couche d'apprêt telle que décrite précédemment.

En particulier, la feuille arrière peut comporter une succession de couches superposées les unes aux autres, en particulier jointives, dans l'ordre suivant :
- PVF, PET, polyoléfine, notamment PVF, PET, PE ;
- PVDF, PET, polyoléfine, notamment PVDF, PET, PE ;
- PVF, PET, PVF ;
- PVDF, PET, PVDF ;
- PVF, PET, PVDF ;
- PVDF, PET, PVF;
- PVDF, aluminium, PET, polyoléfine, notamment PVDF, aluminium, PET, PE; ou
- PVF, aluminium, PET, polyoléfine, notamment PVF, aluminium, PET, PE;
en particulier la feuille arrière peut comporter une succession de couches superposées les unes aux autres, en particulier jointives, dans l'ordre suivant :
- PVDF, PET, polyoléfine, notamment PVDF, PET, PE ;
- PVDF, PET, PVDF ; ou
- PVDF, aluminium, PET, polyoléfine, notamment PVDF, aluminium, PET, PE.

La feuille arrière mise en œuvre dans le procédé selon l'invention peut être obtenue à partir d'un module photovoltaïque, en particulier usagé ou défectueux.

En particulier, le procédé de l'invention comprend préalablement à l'étape a) la récupération de la feuille arrière par désassemblage d'un module photovoltaïque, en particulier usagé ou défectueux.

En particulier, la feuille arrière ne subit aucune modification de sa structure préalablement à l'étape a). En variante, la feuille arrière peut être découpée et/ou broyée préalablement à l'étape a) pour obtenir la feuille arrière sous la forme de morceaux de surface comprise entre 0,1 cm² et 1000 cm², en particulier entre 1 cm² et 100 cm².

La composition d'une feuille arrière ou de chacune de ses couches peut être analysée par spectroscopie infrarouge à transformée de Fourier (ou encore FTIR selon la terminologie anglo-saxonne « *Fourier Transform InfraRed spectroscopy »)* avec réflectance totale atténuée (ou encore ATR selon la terminologie anglo-saxonne *« Attenuated Total Reflectance »),* encore nommée FTIR-ATR, ou par calorimétrie différentielle à balayage (ou encore DSC selon la terminologie anglo-saxonne « *Differential Scanning Calorimetry »).*

### Solvant eutectique profond

A l'étape b), la feuille arrière est délaminée au contact d'au moins un solvant eutectique profond.

Les solvants eutectiques profonds (dits *« deep eutectic solvents »* ou DES selon la terminologie anglo-saxonne) sont généralement composés de deux ou plusieurs constituants, notamment deux ou trois constituants, qui sont capables d'auto-association, en particulier par des liaisons hydrogène ou des liaisons de van der Waals, pour former un mélange eutectique présentant un point de fusion inférieur à celui de chaque constituant pris individuellement. En particulier, les DES convenant à l'invention sont composés d'un mélange de deux ou plusieurs constituants distincts, notamment de deux constituants distincts, les constituants dudit mélange étant de préférence mis en œuvre dans les proportions correspondant au point eutectique dudit mélange.

Les DES consistent généralement en un mélange d'au moins un acide et d'au moins une base pouvant comporter une ou plusieurs espèces anioniques et/ou cationiques, l'acide et la base étant notamment un acide et une base de Lewis ou un acide et une base de Brønsted. En particulier, les DES peuvent consister en un mélange d'au moins un composé accepteur de liaison hydrogène, également appelé composé HBA (acronyme anglo-saxon pour « Hydrogen Bond Acceptor ») ou premier composé, et d'au moins un composé donneur de liaison hydrogène, également appelé composé HBD (acronyme anglo-saxon pour « Hydrogen Bond Donor ») ou deuxième composé. Il est entendu que le composé HBA est distinct du composé HBD.

Les DES ont l'avantage de présenter une très faible tension de vapeur et donc d'être non volatils. De plus, les DES sont, de manière avantageuse, généralement biodégradables, non toxiques, non inflammables et issus de molécules biosourcées. Ils sont ainsi plus respectueux de l'environnement que de nombreux solvants. Enfin, leur procédé de préparation est simple, peu coûteux et en particulier ne nécessite aucune étape de purification.

Le solvant eutectique profond (DES) peut être hydrophile ou hydrophobe. De préférence, le DES est hydrophobe. Au sens de l'invention, par « DES hydrophobe », on entend signifier que le DES est peu voire non miscible avec l'eau, en particulier présente une solubilité dans l'eau inférieure ou égale à 70 g/L, notamment inférieure ou égale à 40 g/L, voire inférieure ou égale à 30 g/L, voire même inférieure ou égale à 20 g/L. Des exemples de DES hydrophobes ont été décrits par Makoś *et al. [4].*

En particulier, le DES peut être non ionique Au sens de l'invention, par « DES non ionique », on entend signifier que les constituants du DES sont non ioniques, c'est-à-dire que les constituants du DES ne comportent pas de charge.

Un DES convenant à l'invention peut combiner au moins un composé donneur de liaison hydrogène (composé HBD), à au moins un composé accepteur de liaison hydrogène (composé HBA).

Chacun de ces composés peut être formé par un unique composé ou un mélange d'au moins deux composés.

Comme précisé dans Makoś *et al.* [4], dans le cas des DES non ioniques, il peut être difficile d'attribuer un caractère HBD ou HBA à chacun des composés. Les composés HBD, respectivement HBA, peuvent être considérés dans la littérature comme composés HBA, respectivement composés HBD. Par exemple, un composé HBD, respectivement HBA, vis-à-vis d'un composé peut être considéré comme composé HBA, respectivement HBD, vis-à-vis d'un autre composé.

### Composé accepteur de liaison hydrogène (HBA)

Le composé HBA peut être choisi parmi les sels halogénés d'ammonium, de phosphonium ou de sulfonium.

Le sel halogéné peut être un sel de fluorure, de chlorure, de bromure ou d'iodure, en particulier de chlorure ou de bromure. En particulier, le sel halogéné d'ammonium, de phosphonium ou de sulfonium est un chlorure d'ammonium, de phosphonium ou de sulfonium.

Le sel halogéné peut être un sel halogéné d'ammonium primaire, secondaire, tertiaire ou quaternaire. Le sel halogéné peut être par exemple de formule R¹R²R³R⁴N⁺A⁻, avec A un atome d'halogène et R¹, R², R³ et R⁴ étant indépendamment les uns des autres un atome d'hydrogène ou un radical alkyle linéaire ou ramifié en C₁ à C₂₂, notamment en C₁ à C₁₀, voire en C₁ à C₅, pouvant être substitué par un ou plusieurs groupes hydroxyles, phényles, - COOH, -C(O)OR', -OR' avec R' étant un radical alkyle en C₁ à C₅, -COCl, -OCOCl, -Cl ou -F, en particulier au moins un, notamment au moins deux, voire au moins trois, voire même au moins quatre de R¹, R², R³ et R⁴ étant un radical alkyle linéaire ou ramifié tel que défini précédemment. Selon un mode de réalisation particulier, R¹, R², R³ et R⁴ sont indépendamment les uns des autres un radical alkyle linéaire ou ramifié en C₁ à C₂₂.

Le sel halogéné peut aussi être un sel halogéné de phosphonium primaire, secondaire, tertiaire ou quaternaire. Le sel halogéné peut être par exemple de formule R¹R²R³R⁴P⁺A⁻, avec A, R¹, R², R³ et R⁴ étant tels que définis précédemment.

Le sel halogéné peut aussi être un sel halogéné de sulfonium. Le sel halogéné peut être par exemple de formule R¹R²R³S⁺A⁻, avec A étant tel que défini précédemment et R¹, R² et R³ étant indépendamment les uns des autres un radical alkyle linéaire ou ramifié en C₁ à C₂₂, notamment en C₁ à C₁₀, voire en C₁ à C₅, pouvant être substitué par un ou plusieurs groupes hydroxyles, phényles, -COOH, -C(O)OR', -OR' avec R' étant un radical alkyle en C₁ à C₅, -COCl, -OCOCl, -Cl ou -F.

L'atome d'halogène A peut être un atome de fluor, de chlore, de brome ou d'iode.

Par exemple, le DES peut comprendre au moins un sel d'ammonium quaternaire halogéné ou un sel de phosphonium quaternaire halogéné, de préférence au moins un sel d'ammonium quaternaire halogéné, à titre de composé HBA.

Le DES peut en particulier comprendre un chlorure d'ammonium quaternaire ou un bromure d'ammonium quaternaire, de préférence un chlorure d'ammonium quaternaire, à titre de composé HBA.

En particulier, le composé HBA peut être choisi parmi les halogénures de choline, les halogénures de N-éthyl-2-hydroxy-N,N-diméthyléthanaminium, les halogénures de 2-(chlorocarbonyloxy)-N,N,N-triméthyl-ethanaminium, les halogénures de N-benzyl-2-hydroxy-N,N-diméthyléthanaminium, les halogénures de tétrabutylammonium, les halogénures de méthyltrioctylammonium, les halogénures de tétraoctylammonium, les halogénures d'éthyltrioctylammonium, les halogénures de tétraheptylammonium et leurs mélanges, plus particulièrement parmi les chlorures de choline, les chlorures de N-éthyl-2-hydroxy-N,N-diméthyléthanaminium, les chlorures de 2-(chlorocarbonyloxy)-N,N,N-triméthyl-ethanaminium, les chlorures de N-benzyl-2-hydroxy-N,N-diméthyléthanaminium, les chlorures de tétrabutylammonium, les chlorures de méthyltrioctylammonium, les chlorures de tétraoctylammonium, les chlorures d'éthyltrioctylammonium, les chlorures de tétraheptylammonium et leurs mélanges. En particulier, le composé accepteur de liaison hydrogène peut être choisi parmi les halogénures de choline, les halogénures de N-éthyl-2-hydroxy-N,N-diméthyléthanaminium, les halogénures de 2-(chlorocarbonyloxy)-N,N,N-triméthyl-ethanaminium, les halogénures de N-benzyl-2-hydroxy-N,N-diméthyléthanaminium et leurs mélanges, plus préférentiellement parmi le chlorure de choline, le chlorure de N-éthyl-2-hydroxy-N,N-diméthyléthanaminium, le chlorure de 2-(chlorocarbonyloxy)-N,N,N-triméthyl-ethanaminium, le chlorure de N-benzyl-2-hydroxy-N,N-diméthyléthanaminium et leurs mélanges.

Selon un mode de réalisation particulier de l'invention, le solvant eutectique profond comprend au moins du chlorure de choline à titre de composé accepteur de liaison hydrogène.

Le composé HBA peut aussi être choisi parmi les monoterpénoïdes comportant au moins un groupe fonctionnel oxygéné, et leurs mélanges, notamment parmi les monoterpénoïdes comportant au moins un groupe hydroxyle, les monoterpénoïdes comportant au moins un groupe carbonyle, les monoterpénoïdes comportant au moins un groupe ester, les monoterpénoïdes comportant au moins un groupe éther cyclique et leurs mélanges. Plus particulièrement, le composé accepteur de liaison hydrogène peut être choisi parmi le thymol (5-méthyl-2-(propan-2-yl)-phénol), la carvone (5-isopropenyl-2-methyl-2-cyclohexénone), l'eucalyptol (1,8-cinéol), le bornéol, le carvacrol, l'acétate de bornyle, le camphre, le citral, le citronellal, le géraniol, l'hinokitiol, l'iridoïde, le linalol et leurs mélanges, notamment parmi le thymol, la carvone, l'eucalyptol et leurs mélanges.

En particulier, le composé accepteur de liaison hydrogène peut être choisi parmi les monoterpénoïdes comportant au moins un groupe hydroxyle, les monoterpénoïdes comportant au moins un groupe carbonyle, les monoterpénoïdes comportant au moins un groupe éther cyclique, et leurs mélanges, notamment parmi le thymol, la carvone, le bornéol, le carvacrol, l'eucalyptol et leurs mélanges.

Plus particulièrement, le composé accepteur de liaison hydrogène peut être choisi parmi les monoterpénoïdes comportant au moins un groupe hydroxyle, les monoterpénoïdes comportant au moins un groupe carbonyle, et leurs mélanges, notamment parmi le thymol, la carvone et leurs mélanges.

En particulier, le composé HBA peut être choisi parmi les monoterpénoïdes comportant au moins un groupe hydroxyle et leurs mélanges. De préférence, le DES comprend, à titre de composé HBA, au moins le thymol.

Le composé HBA peut aussi être choisi parmi les benzènes substitués par un groupe -NH-C(=O)-Y avec Y représentant une chaîne aliphatique linéaire ou ramifiée, saturée ou insaturée, interrompue par au moins un atome d'azote, le benzène étant optionnellement substitués un ou plusieurs radicaux alkyles linéaires ou ramifiés en C₁ à C₅, notamment en C₁ à C₃. En particulier, Y représente un groupement -(CH₂)ₚ-N-R^{h}Rⁱ, dans lequel p est un entier compris entre 1 et 5, notamment entre 1 et 3, voire égal à 1, R^{h} et R' sont indépendamment l'un de l'autre un radical alkyle linéaire ou ramifié en C₁ à C₅, notamment en C₁ à C₃ voire un groupe éthyle.

En particulier, le composé HBA peut être la lidocaïne (2-(diéthylamino)-N-(2,6-diméthylphényl)acétamide).

Le composé HBA peut aussi être choisi parmi les acides carboxyliques comprenant une ou plusieurs fonctions carboxyliques, en particulier parmi les acides monocarboxyliques, les acides dicarboxyliques et les acides tricarboxyliques, plus particulièrement parmi les acides dicarboxyliques.

Le composé HBA peut être un acide monocarboxylique choisi parmi :
- les acides monocarboxyliques hydrocarbonés non aromatiques, non substitués, saturés ou insaturés, linéaires ou ramifiés, en particulier parmi les acides monocarboxyliques hydrocarbonés non aromatiques, non substitués, saturés ou insaturés, linéaires ou ramifiés, possédant de 1 à 24 atomes de carbone, en particulier de 6 à 20 atomes de carbone, voire de 6 à 18 atomes de carbone ; et
- les acides monocarboxyliques aromatiques saturés ou insaturés, en particulier parmi les acides monocarboxyliques aromatiques saturés ou insaturés, possédant de 6 à 12 atomes de carbone, en particulier possédant 7 atomes de carbone.

Le composé HBA peut être choisi parmi l'acide formique, l'acide benzoïque, l'acide hexanoïque, l'acide heptanoïque, l'acide octanoïque, l'acide décanoïque, l'acide dodécanoïque, l'acide myristique, l'acide palmitique, l'acide stéarique, l'acide linoléique, l'acide oléique et leurs mélanges.

En particulier, le composé HBA peut être choisi parmi les acides monocarboxyliques aliphatiques non substitués, saturés ou insaturés, linéaires ou ramifiés, possédant de 6 à 20 atomes de carbone, en particulier de 6 à 18 atomes de carbone, notamment de 8 à 14 atomes de carbone, voire de 10 à 12 atomes de carbone, plus particulièrement parmi les acides monocarboxyliques aliphatiques non substitués, saturés et linéaires possédant de 6 à 20 atomes de carbone, en particulier de 6 à 18 atomes de carbone, notamment de 8 à 14 atomes de carbone, voire de 10 à 12 atomes de carbone.

En particulier, le composé HBA peut être choisi parmi l'acide hexanoïque, l'acide octanoïque, l'acide décanoïque, l'acide dodécanoïque, l'acide myristique, l'acide linoléique, l'acide oléique et leurs mélanges, plus particulièrement parmi l'acide hexanoïque, l'acide octanoïque, l'acide décanoïque, l'acide dodécanoïque, l'acide myristique et leurs mélanges. En particulier, le DES peut comprendre, à titre de composé HBA, au moins l'acide décanoïque, l'acide dodécanoïque ou leurs mélanges, plus particulièrement au moins l'acide décanoïque.

Le composé HBA peut être un acide dicarboxylique choisi parmi :
- les acides dicarboxyliques hydrocarbonés non aromatiques, non substitués, saturés ou insaturés, linéaires ou ramifiés, possédant de 2 à 10 atomes de carbone, en particulier de 3 à 8 atomes de carbone, voire de 4 à 6 atomes de carbone ; et
- les acides dicarboxyliques aromatiques possédant de 7 à 13 atomes de carbone, en particulier possédant 8 atomes de carbone.

Le composé HBA peut être un acide dicarboxylique choisi parmi l'acide téréphtalique et les acides dicarboxyliques hydrocarbonés non aromatiques, non substitués, saturés ou insaturés, linéaires ou ramifiés, possédant de 2 à 10 atomes de carbone, en particulier de 3 à 8 atomes de carbone, voire de 4 à 6 atomes de carbone.

En particulier, le composé HBA peut être un acide dicarboxylique choisi parmi les acides dicarboxyliques hydrocarbonés non aromatiques, non substitués, saturés ou insaturés, linéaires ou ramifiés, possédant de 2 à 10 atomes de carbone, notamment de 3 à 8 atomes de carbone, voire de 4 à 6 atomes de carbone, en particulier parmi les acides dicarboxyliques hydrocarbonés non aromatiques, non substitués, saturés et linéaires, possédant de 2 à 10 atomes de carbone, notamment de 3 à 8 atomes de carbone, voire de 4 à 6 atomes de carbone. En particulier, le composé donneur de liaison hydrogène peut être choisi parmi l'acide oxalique, l'acide malonique, l'acide succinique, l'acide adipique, l'acide azélaique et leurs mélanges, en particulier peut être l'acide succinique.

Le composé HBA peut aussi être un acide tricarboxylique, éventuellement substitués par un ou plusieurs groupes hydroxyles, en particulier l'acide citrique.

De préférence, le composé HBA est choisi parmi les sels halogénés d'ammonium, de phosphonium ou de sulfonium, notamment tels que décrits précédemment, et les monoterpénoïdes comportant au moins un groupe fonctionnel oxygéné, notamment tels que décrits précédemment, plus particulièrement parmi le chlorure de choline et le thymol. Avantageusement, le composé HBA est choisi parmi les monoterpénoïdes comportant au moins un groupe fonctionnel oxygéné, notamment tels que décrits précédemment, pour procurer au DES un caractère hydrophobe et non ionique.

En particulier, le DES comprend au moins un composé accepteur de liaison hydrogène (HBA) choisi parmi :
- les sels halogénés d'ammonium, de phosphonium ou de sulfonium et leurs mélanges, et
- les monoterpénoïdes comportant au moins un groupe fonctionnel oxygéné et leurs mélanges ;

en particulier parmi :
   - les chlorures d'ammonium quaternaire, les bromures d'ammonium quaternaire et leurs mélanges, et
   - les monoterpénoïdes comportant au moins un groupe hydroxyle, les monoterpénoïdes comportant au moins un groupe carbonyle, les monoterpénoïdes comportant au moins un groupe éther cyclique et leurs mélanges ;
plus particulièrement choisi parmi :
   - le chlorure de choline, le chlorure de N-éthyl-2-hydroxy-N,N-diméthyléthanaminium, le chlorure de 2-(chlorocarbonyloxy)-N,N,N-triméthyl-ethanaminium, le chlorure de N-benzyl-2-hydroxy-N,N-diméthyléthanaminium et leurs mélanges, et
   - la carvone, l'eucalyptol, le thymol et leurs mélanges,
notamment choisi parmi le chlorure de choline et le thymol.

En particulier, le DES peut comprendre au moins un composé accepteur de liaison hydrogène (HBA) choisi parmi les monoterpénoïdes comportant au moins un groupe fonctionnel oxygéné et leurs mélanges, en particulier parmi les monoterpénoïdes comportant au moins un groupe hydroxyle, les monoterpénoïdes comportant au moins un groupe carbonyle, les monoterpénoïdes comportant au moins un groupe éther cyclique et leurs mélanges, plus particulièrement parmi la carvone, l'eucalyptol, le thymol et leurs mélanges. De préférence, le DES comprend au moins le thymol à titre de composé HBA.

### Composé donneur de liaison hydrogène (HBD)

Le composé HBD peut être choisi parmi les composés de formule (I) :

HR^{a}N-C(=X)-R^{d} (I)

avec :
- X étant choisi parmi un atome d'oxygène et un atome de soufre,
- R^{a} étant choisi parmi un atome d'hydrogène et un radical alkyle linéaire ou ramifié en C₁ à C₅, notamment en C₁ à C₄, pouvant être substitué par un ou plusieurs, notamment un ou deux, groupes hydroxyles, et
- R^{d} étant choisi parmi un radical alkyle linéaire ou ramifié en C₁ à C₅, notamment en C₁ à C₄ pouvant être substitué par un ou plusieurs, notamment un ou deux, groupes hydroxyles, un radical phényl pouvant être substitué par un ou plusieurs, notamment un ou deux, groupes hydroxyles, et un radical -NR^{b}R^{c} avec R^{b} étant choisi parmi un atome d'hydrogène et un radical alkyle linéaire ou ramifié en C₁ à C₅, notamment C₁ à C₄ pouvant être substitué par un ou plusieurs, notamment un ou deux, groupes hydroxyles et R^{c} étant choisi parmi un atome d'hydrogène, un radical alkyle linéaire ou ramifié en C₁ à C₅, notamment C₁ à C₄ pouvant être substitué par un ou plusieurs, notamment un ou deux, groupes hydroxyles, et un radical -C(=X)-NRⁱR^{k} avec X étant tel que défini précédemment et R^{j} et R^{k} étant indépendamment l'un de l'autre choisis parmi un atome d'hydrogène et un radical alkyle linéaire ou ramifié en C₁ à C₅, notamment C₁ à C₄ pouvant être substitué par un ou plusieurs, notamment un ou deux, groupes hydroxyles,
en particulier R^{d} étant choisi parmi un radical alkyle linéaire ou ramifié en C₁ à C₅, notamment C₁ à C₄ pouvant être substitué par un ou plusieurs groupes hydroxyles, et un radical -NR^{b}R^{c} avec R^{b} et R^{c} étant tels que définis précédemment.

En particulier, le composé HBD peut être choisi parmi les composés de formule (I) avec :
- X étant choisi parmi un atome d'oxygène et un atome de soufre, en particulier étant l'atome d'oxygène,
- R^{a} étant choisi parmi un atome d'hydrogène et un radical alkyle linéaire ou ramifié en C₁ à C₄, en particulier parmi un atome d'hydrogène et un radical alkyle linéaire ou ramifié en C₁ à C₂, plus particulièrement parmi un atome d'hydrogène et un groupe méthyle, et
- R^{d} étant un radical alkyle linéaire ou ramifié en C₁ à C₄, en particulier un radical alkyle linéaire ou ramifié en C₁ à C₂, plus particulièrement un groupe méthyle.

En particulier, le composé HBD peut être choisi parmi les composés de formule (I') :

HR^{a}N-C(=X)-NR^{b}R^{c} (I'),

avec :
- X étant choisi parmi un atome d'oxygène et un atome de soufre, en particulier étant l'atome d'oxygène,
- R^{a} et R^{b} étant indépendamment l'un de l'autre choisis parmi un atome d'hydrogène et un radical alkyle linéaire ou ramifié en C₁ à C₄, en particulier en Ci ou C₂, et
- R^{c} étant choisi parmi un atome d'hydrogène, un radical alkyle linéaire ou ramifié en C₁ à C₄, en particulier en C₁ ou C₂, et un radical -C(=X)-NR^{j}R^{k} avec X étant tel que défini précédemment et R^{j} et R^{k} étant indépendamment l'un de l'autre choisis parmi un atome d'hydrogène et un radical alkyle linéaire ou ramifié en C₁ à C₄, en particulier en C₁ ou C₂, en particulier :
- X étant choisi parmi un atome d'oxygène et un atome de soufre, en particulier étant l'atome d'oxygène, et
- R^{a}, R^{b} et R^{c} étant indépendamment les uns des autres choisis parmi un atome d'hydrogène et un radical alkyle linéaire ou ramifié en C₁ à C₅, notamment en C₁ à C₄, en particulier en C₁ ou C₂, plus particulièrement, au moins un, notamment au moins deux de R^{a}, R^{b} et R^{c} peut être un atome d'hydrogène.

En particulier, le composé HBD peut être choisi parmi l'urée, la N-méthylurée, la N,N'-diméthylurée, la N,N-diméthylurée, le biuret, la thiourée, l'acétamide, la N-méthylacétamide, et leurs mélanges, plus particulièrement parmi l'urée, la N-méthylurée, la N,N'-diméthylurée, la N,N-diméthylurée, l'acétamide, la N-méthylacétamide et leurs mélanges.

De préférence, le composé donneur de liaison hydrogène est l'urée de formule CO(NH₂)₂.

Le composé HBD peut aussi être choisi parmi les acides carboxyliques comprenant une ou plusieurs fonctions carboxyliques, en particulier parmi les acides monocarboxyliques, les acides dicarboxyliques et les acides tricarboxyliques, de préférence parmi les acides monocarboxyliques.

Le composé HBD peut être un acide monocarboxylique choisi parmi :
- les acides monocarboxyliques hydrocarbonés non aromatiques, saturés ou insaturés, linéaires ou ramifiés, pouvant être substitués par un ou plusieurs groupements hydroxyles ou par un ou plusieurs groupements phényles, en particulier parmi les acides monocarboxyliques hydrocarbonés non aromatiques, non substitués, saturés ou insaturés, linéaires ou ramifiés, possédant de 1 à 24 atomes de carbone, en particulier de 6 à 20 atomes de carbone, voire de 6 à 18 atomes de carbone ; et
- les acides monocarboxyliques aromatiques saturés ou insaturés, en particulier parmi les acides monocarboxyliques aromatiques saturés ou insaturés possédant de 6 à 12 atomes de carbone, notamment possédant 7 atomes de carbone.

Le composé HBD peut être choisi parmi l'acide formique, l'acide lactique, l'acide benzoïque, l'acide 3-phenylpropionique, l'acide hexanoïque, l'acide heptanoïque, l'acide octanoïque, l'acide décanoïque, l'acide dodécanoïque, l'acide myristique, l'acide palmitique, l'acide stéarique, l'acide linoléique, l'acide oléique et leurs mélanges, en particulier parmi l'acide formique, l'acide lactique, l'acide 3-phenylpropionique, l'acide hexanoïque, l'acide heptanoïque, l'acide octanoïque, l'acide décanoïque, l'acide dodécanoïque et leurs mélanges, plus particulièrement parmi l'acide lactique, l'acide hexanoïque, l'acide heptanoïque, l'acide octanoïque, l'acide décanoïque, l'acide dodécanoïque et leurs mélanges.

De préférence, le composé HBD est choisi parmi les acides monocarboxyliques aliphatiques non substitués, saturés ou insaturés, linéaires ou ramifiés, possédant de 6 à 20 atomes de carbone, en particulier de 6 à 18 atomes de carbone, notamment de 8 à 14 atomes de carbone, voire de 10 à 12 atomes de carbone, notamment parmi les acides monocarboxyliques aliphatiques non substitués, saturés, linéaires ou ramifiés, possédant de 6 à 20 atomes de carbone, en particulier de 6 à 18 atomes de carbone, notamment de 8 à 14 atomes de carbone, voire de 10 à 12 atomes de carbone, voire parmi les acides monocarboxyliques aliphatiques non substitués, saturés et linéaires possédant de 6 à 20 atomes de carbone, en particulier de 6 à 18 atomes de carbone, notamment de 8 à 14 atomes de carbone, voire de 10 à 12 atomes de carbone.

Un acide monocarboxylique aliphatique peut être un composé de formule R¹-COOH, avec R¹ étant un groupe alkyle linéaire ou ramifié en C₅ à C₁₉ ou un groupe alcényle linéaire ou ramifié en C₅ à C₁₉, en particulier R¹ étant un groupe alkyle linéaire ou ramifié en C₅ à C₁₉. Un acide monocarboxylique aliphatique non substitué, saturé et linéaire peut être un composé de formule CH₃-(CH₂)ₙ-COOH, avec n étant un entier compris entre 4 et 18, en particulier entre 6 et 12, notamment entre 8 et 10.

En particulier, le composé HBD peut être choisi parmi l'acide hexanoïque, l'acide heptanoïque, l'acide octanoïque, l'acide décanoïque, l'acide dodécanoïque, l'acide myristique, l'acide palmitique, l'acide stéarique, l'acide linoléique, l'acide oléique et leurs mélanges, plus particulièrement parmi l'acide hexanoïque, l'acide heptanoïque, l'acide octanoïque, l'acide décanoïque, l'acide dodécanoïque, l'acide myristique, l'acide stéarique et leurs mélanges, encore plus particulièrement parmi l'acide hexanoïque, l'acide heptanoïque, l'acide octanoïque, l'acide décanoïque, l'acide dodécanoïque et leurs mélanges. De préférence, le DES comprend, à titre de composé HBD, au moins l'acide décanoïque, l'acide dodécanoïque ou leurs mélanges, plus préférentiellement au moins l'acide décanoïque.

Le composé HBD peut être un acide dicarboxylique choisi parmi :
- les acides dicarboxyliques hydrocarbonés non aromatiques, non substitués, saturés ou insaturés, linéaires ou ramifiés, possédant de 2 à 10 atomes de carbone ; et
- les acides dicarboxyliques aromatiques possédant de 8 à 13 atomes de carbone, en particulier possédant 8 atomes de carbone.

Le composé HBD peut être un acide dicarboxylique choisi parmi l'acide téréphtalique et les acides dicarboxyliques hydrocarbonés non aromatiques, non substitués, saturés ou insaturés, linéaires ou ramifiés, possédant de 2 à 10 atomes de carbone, en particulier parmi l'acide téréphtalique, l'acide oxalique, l'acide malonique, l'acide succinique, l'acide adipique, l'acide azélaique et leurs mélanges.

Le composé HBD peut être un acide dicarboxylique choisi parmi les acides dicarboxyliques hydrocarbonés non aromatiques, non substitués, saturés ou insaturés, linéaires ou ramifiés, possédant de 2 à 10 atomes de carbone, en particulier parmi les acides dicarboxyliques hydrocarbonés non aromatiques, non substitués, saturés, linéaires ou ramifiés, possédant de 2 à 10 atomes de carbone, plus particulièrement parmi les acides dicarboxyliques hydrocarbonés non aromatiques, non substitués, saturés et linéaires, possédant de 2 à 10 atomes de carbone.

Le composé HBD peut être choisi parmi les acides dicarboxyliques linéaires et saturés de formule HOOC-(CH₂)_{q}-COOH dans laquelle q est un entier compris entre 0 et 8. En particulier, le composé donneur de liaison hydrogène peut être choisi parmi l'acide oxalique, l'acide malonique, l'acide succinique, l'acide adipique, l'acide azélaique et leurs mélanges. Le composé donneur de liaison hydrogène peut aussi être un acide tricarboxylique, éventuellement substitués par un ou plusieurs groupes hydroxyles, en particulier l'acide citrique.

Il est entendu que, lorsque le composé HBD est un acide carboxylique, le composé HBA est distinct du composé HBD.

Le composé HBD peut aussi être choisi parmi les benzènes substitués par :
- un groupe aldéhyde,
- un groupe de formule -OR^{e} avec R^{e} étant un radical alkyle linéaire ou ramifié en C₁ à C₅, notamment en C₁ à C₃, voire étant un groupe méthyle,
- un groupe de formule -C(=O)-O-X avec X représentant un groupe aromatique hydrocarboné pouvant être substitué un ou plusieurs radicaux alkyles linéaires ou ramifiés en C₁ à C₅, notamment en C₁ à C₃, et/ou
- un groupe -NH-C(=O)-Y avec Y représentant une chaîne aliphatique linéaire ou ramifiée, saturée ou insaturée, interrompue par au moins un atome d'azote,
et optionnellement substitués par un ou plusieurs groupes choisis parmi :
- les groupes hydroxyles,
- les groupes de formule -NR^{f}R^{g} avec R^{f} et R^{g} étant indépendamment l'un de l'autre un radical alkyle linéaire ou ramifié en C₁ à C₅, notamment en C₁ à C₃ voire étant un groupe méthyle, et/ou
- les radicaux alkyles linéaires ou ramifiés en C₁ à C₅, notamment en C₁ à C₃.

Le composé HBD peut être choisi parmi les benzaldéhyles, en particulier parmi les benzaldéhydes substitués, notamment en position para et/ou meta du groupe aldéhyde, par un ou plusieurs groupes choisis parmi les groupes hydroxyles, les groupes de formule -OR^{e} avec R^{e} étant tel que défini précédemment, et les groupes de formule -NR^{f}R^{g} avec R^{f} et R^{g} étant tels que définis précédemment, de préférence parmi les benzaldéhyles substitués en position para du groupe aldéhyde par un groupe choisi parmi les groupes hydroxyles et les groupes de formule -NR^{f}R^{g} avec R^{f} et R^{g} étant tels que définis précédemment, et optionnellement substitués en position meta des groupes aldéhydes par un groupe de formule -OR^{e} avec R^{e} étant tel que défini précédemment.

En particulier, le composé HBD peut être choisi parmi les benzaldéhydes substitués en position para du groupe aldéhyde par un groupe de formule -NR^{f}R^{g} avec R^{f} et R^{g} étant tels que définis précédemment, et optionnellement substitués en position ortho ou meta du groupe aldéhyde par un ou plusieurs radicaux alkyles linéaire ou ramifiés en C₁ à C₅, notamment en C₁ à C₃, voire par un ou plusieurs groupes méthyl, plus particulièrement parmi les benzaldéhydes substitués en position para du groupe aldéhyde par un groupe de formule -NR^{f}R^{g} avec R^{f} et R^{g} étant tels que définis précédemment.

En particulier, le composé HBD peut être choisi parmi le 4-diméthylaminobenzaldéhyde, encore nommé 4-DMAB, la vanilline (4-hydroxyl-3-méthoxybenzaldéhyde), la lidocaïne (2-(diéthylamino)-N-(2,6-diméthylphényl)acétamide), le salicylate de phényle, le méthoxybenzène (encore appelé anisole) et leurs mélanges.

Le composé HBD peut aussi être choisi parmi les benzènes substitués par :
- un groupe -NH-C(=O)-Y avec Y représentant une chaîne aliphatique linéaire ou ramifiée, saturée ou insaturée, interrompue par au moins un atome d'azote, en particulier, Y représente un groupement -(CH₂)ₚ-N-R^{h}Rⁱ, dans laquelle p est un entier compris entre 1 et 5, notamment entre 1 et 3, voire égal à 1, R^{h} et Rⁱ étant indépendamment l'un de l'autre un radical alkyle linéaire ou ramifié en C₁ à C₅, notamment en C₁ à C₃ voire étant un groupe éthyle ;
- un groupe aldéhyde, un groupe hydroxyle en position para du groupe aldéhyde et un groupe de formule -OR^{e} avec R^{e} étant tel que défini précédemment en position meta du groupe aldéhyde ; ou
- un groupe de formule -OR^{e} avec R^{e} étant tel que défini précédemment ;
le benzène étant optionnellement substitués par un ou plusieurs radicaux alkyles linéaires ou ramifiés en C₁ à C₅, notamment en C₁ à C₃.

En particulier, le composé HBD peut être choisi parmi la vanilline, la lidocaïne, le méthoxybenzène et leurs mélanges.

Certains de ces composés, notamment la lidocaïne, peuvent être mis en œuvre à la fois comme HBD et comme HBA. Il est entendu que le composé HBA est un composé distinct du composé HBD. En particulier, lorsque le composé HBD est la lidocaïne, le composé HBA est distinct de la lidocaïne.

Le composé HBD peut aussi être choisi parmi les alcools aliphatiques non substitués, linéaires ou ramifiés, saturés ou insaturés, possédant de 8 à 18 atomes de carbone, notamment de 12 à 16 atomes de carbones, en particulier parmi les alcools aliphatiques non substitués, linéaires et saturés possédant de 8 à 18 atomes de carbone, notamment de 12 à 16 atomes de carbone. En particulier, le composé HBD peut être le 1-tétradécanol.

Le composé HBD peut aussi être la coumarine (2H-1-benzopyrane-2-one) ou l'eau, en particulier l'eau.

Le composé HBD peut aussi être choisi parmi les monoterpénoïdes comportant au moins un groupe fonctionnel oxygéné et leurs mélanges, notamment tels que décrits précédemment. Le composé HBD peut être un monoterpénoïde choisi parmi le thymol, la carvone, l'eucalyptol, le bornéol, le carvacrol, l'acétate de bornyle, le camphre, le citral, le citronellal, le géraniol, l'hinokitiol, l'iridoïde, le linalol et leurs mélanges, notamment parmi le thymol et leurs mélanges.

En particulier, un monoterpénoïde peut être mis en œuvre à la fois comme HBD et comme HBA. Il est entendu que, lorsque le composé HBD est un monoterpénoïde, le composé HBA est un composé distinct du composé HBD, par exemple peut être un monoterpénoïde distinct du monoterpénoïde mis en œuvre à titre de composé HBD.

Le DES peut comprendre au moins un composé HBD choisi parmi :
- les acides monocarboxyliques aliphatiques non substitués, saturés ou insaturés, linéaires ou ramifiés, possédant de 6 à 20 atomes de carbone, notamment tels que décrits précédemment,
- les acides dicarboxyliques hydrocarbonés non aromatiques, non substitués, saturés, linéaires ou ramifiés, possédant de 2 à 10 atomes de carbone, notamment tels que décrits précédemment,
- l'acide formique, l'acide lactique, l'acide téréphtalique, l'acide 3-phénylpropionique, l'acide citrique,
- les composés de formule HR^{a}N-C(=X)-R^{d} (I), avec X étant choisi parmi un atome d'oxygène et un atome de soufre, R^{a} étant choisi parmi un atome d'hydrogène et un radical alkyle linéaire ou ramifié en C₁ à C₄, et R^{d} étant choisi parmi un radical alkyle linéaire ou ramifié en C₁ à C₄, et un radical -NR^{b}R^{c} avec R^{b} et R^{c} étant indépendamment l'un de l'autre choisis parmi un atome d'hydrogène et un radical alkyle linéaire ou ramifié en C₁ à C₄,
- la vanilline, la lidocaïne, le méthoxybenzène,
- l'eau,

et leurs mélanges,
en particulier parmi l'acide formique, l'acide lactique, l'acide 3-phenylpropionique, l'acide hexanoïque, l'acide heptanoïque, l'acide octanoïque, l'acide décanoïque, l'acide dodécanoïque, l'acide téréphtalique, l'acide oxalique, l'acide malonique, l'acide succinique, l'acide adipique, l'acide azélaique, l'acide citrique, l'urée, la vanilline, la lidocaïne, le méthoxybenzène, l'eau et leurs mélanges.

Selon un mode de réalisation particulier, le composé HBD peut être choisi parmi :
- les acides monocarboxyliques aliphatiques saturés non substitués, linéaires ou ramifiés, possédant de 6 à 18 atomes de carbone, notamment de 8 à 14 atomes de carbone,
- l'acide lactique,
- les composés de formule HR^{a}N-C(=O)-NR^{b}R^{c} (I') avec R^{a}, R^{b} et R^{c} étant indépendamment les uns des autres choisis parmi un atome d'hydrogène et un radical alkyle linéaire ou ramifié en C₁ à C₄,
- l'eau,

et leurs mélanges,
plus particulièrement parmi :
   - les acides monocarboxyliques aliphatiques saturés non substitués, linéaires ou ramifiés, possédant de 6 à 18 atomes de carbone, notamment tels que décrits précédemment,
   - l'acide lactique,
   - les composés de formule HR^{a}N-C(=O)-NR^{b}R^{c} (I') avec R^{a}, R^{b} et R^{c} étant indépendamment les uns des autres choisis parmi un atome d'hydrogène et un radical alkyle linéaire ou ramifié en C₁ à C₄, notamment tels que décrits précédemment,
et leurs mélanges,
en particulier parmi l'acide lactique, l'acide hexanoïque, l'acide heptanoïque, l'acide octanoïque, l'acide décanoïque, l'acide dodécanoïque, l'urée et leurs mélanges,
plus particulièrement parmi l'acide lactique, l'acide octanoïque, l'acide décanoïque, l'acide dodécanoïque, l'urée et leurs mélanges,
notamment parmi l'acide lactique, l'acide décanoïque, l'urée et leurs mélanges,
voire parmi l'acide lactique, l'acide décanoïque et leurs mélanges.

Selon un mode de réalisation particulier, le composé HBD peut être choisi parmi :
- les acides monocarboxyliques aliphatiques saturés non substitués, linéaires ou ramifiés, possédant de 6 à 18 atomes de carbone, notamment tels que décrits précédemment,
- l'acide lactique,
- l'eau,

et leurs mélanges,
en particulier parmi l'acide lactique, l'acide hexanoïque, l'acide heptanoïque, l'acide octanoïque, l'acide décanoïque, l'acide dodécanoïque, l'eau et leurs mélanges,
plus particulièrement parmi l'acide lactique, l'acide octanoïque, l'acide décanoïque, l'acide dodécanoïque, l'eau et leurs mélanges,
notamment parmi l'acide lactique, l'acide décanoïque, l'eau et leurs mélanges.

En particulier, le DES comprend au moins l'acide lactique, l'acide décanoïque ou l'eau, en particulier l'acide lactique ou l'acide décanoïque, notamment l'acide décanoïque, à titre de composé HBD.

A titre de composés HBD permettant de former un DES hydrophile peuvent être cités l'urée, l'acide oxalique, l'acide malonique, l'acide succinique, l'acide adipique, l'acide citrique, l'acide formique et leurs mélanges.

A titre de composés HBD permettant de former un DES hydrophobe peuvent être cités l'acide hexanoïque, l'acide heptanoïque, l'acide octanoïque, l'acide décanoïque, l'acide dodécanoïque, l'acide azélaïque, l'acide lactique, l'acide 3-phénylpropionique, l'acide téréphtalique, la vanilline, la lidocaïne, le méthoxybenzène, l'urée, l'eau et leurs mélanges.

Le composé HBD et/ou le composé HBA peuvent être sélectionnés pour procurer un caractère hydrophile ou hydrophobe au DES, de préférence hydrophobe.

En particulier, le DES est un solvant eutectique profond de classe V, en particulier comprenant des composés extraits de produits naturels.

En particulier, le DES est non ionique.

Les monoterpénoïdes, en particulier tels que décrits précédemment, sont particulièrement avantageux pour former des DES de classe V non ioniques, en combinaison avec un composé HBD ou HBA non ionique.

Selon un mode de réalisation particulier, le DES est hydrophile, en particulier comprend, voire consiste en :
- au moins un composé HBA choisi parmi les sels halogénés d'ammonium, de phosphonium ou de sulfonium, et leurs mélanges, et
- au moins un composé HBD choisi parmi les acides dicarboxyliques hydrocarbonés non aromatiques, non substitués, saturés, linéaires ou ramifiés, possédant de 2 à 10 atomes de carbone, l'acide citrique, l'acide formique, les composés de formule HR^{a}N-C(=X)-R^{d} (I), avec X étant choisi parmi un atome d'oxygène et un atome de soufre, R^{a} étant choisi parmi un atome d'hydrogène et un radical alkyle, linéaire ou ramifié, en C₁ à C₄, et R^{d} étant choisi parmi un radical alkyle, linéaire ou ramifié, en C₁ à C₄ et un radical -NR^{b}R^{c} avec R^{b} et R^{c} étant indépendamment l'un de l'autre choisis parmi un atome d'hydrogène et un radical alkyle, linéaire ou ramifié, en C₁ à C₄, et leurs mélanges ;

plus particulièrement comprend, voire consiste en :
   - au moins un composé HBA choisi parmi les chlorures d'ammonium quaternaire, les bromures d'ammonium quaternaire et leurs mélanges, et
   - au moins un composé HBD choisi parmi les acides dicarboxyliques hydrocarbonés non aromatiques, non substitués, saturés et linéaires, possédant de 2 à 8 atomes de carbone, l'acide citrique, l'acide formique, les composés de formule HR^{a}N-C(=O)-NR^{b}R^{c} (I') avec R^{a}, R^{b} et R^{c} étant indépendamment les uns des autres choisis parmi un atome d'hydrogène et un radical alkyle, linéaire ou ramifié, en C₁ à C₄,
notamment comprend, voire consiste en :
   - au moins un composé HBA choisi parmi le chlorure de choline, le chlorure de N-éthyl-2-hydroxy-N,N-diméthyléthanaminium, le chlorure de 2-(chlorocarbonyloxy)-N,N,N-triméthyl-ethanaminium, le chlorure de N-benzyl-2-hydroxy-N,N-diméthyléthanaminium, et leurs mélanges, et
   - au moins un composé HBD choisi parmi l'acide oxalique, l'acide malonique, l'acide succinique, l'acide adipique, l'acide citrique, l'acide formique, l'urée et leurs mélanges,
de préférence le DES comprend, voire consiste en, le chlorure de choline et l'urée.

En particulier, le DES est un DES hydrophile comprenant, voire consistant en :
- un mélange d'un composé HBA choisi parmi les chlorures d'ammonium quaternaire, les bromures d'ammonium quaternaire et leurs mélanges, et d'un composé HBD choisi parmi les acides dicarboxyliques hydrocarbonés non aromatiques, non substitués, saturés et linéaires, possédant de 2 à 8 atomes de carbone, l'acide citrique et leurs mélanges, dans un rapport molaire HBA : HBD compris entre 0,2:1 et 5:1, notamment entre 0,5:1 et 1,5:1, voire entre 0,7:1 et 1,3:1, de préférence égal à 1:1 ; ou
- un mélange d'un composé HBA choisi parmi les chlorures d'ammonium quaternaire, les bromures d'ammonium quaternaire et leurs mélanges, et d'un composé HBD choisi parmi l'acide formique, les composés de formule HR^{a}N-C(=O)-NR^{b}R^{c} (I') avec R^{a}, R^{b} et R^{c} étant indépendamment les uns des autres choisis parmi un atome d'hydrogène et un radical alkyle, linéaire ou ramifié, en C₁ à C₄, et leurs mélanges, dans un rapport molaire HBA : HBD compris entre 0,2:2 et 5:2, notamment entre 0,5:2 et 1,5:2, voire entre 0,7:2 et 1,3:2, de préférence égal à 1:2 ;

notamment comprenant, voire consistant en :
   - un mélange de chlorure de choline et d'au moins un composé HBD choisi parmi l'acide oxalique, l'acide malonique, l'acide succinique, l'acide adipique, l'acide citrique et leurs mélanges, dans un rapport molaire chlorure de choline : HBD compris entre 0,2:1 et 5:1, notamment entre 0,5:1 et 1,5:1, voire entre 0,7:1 et 1,3:1, de préférence égal à 1:1 ; ou
   - un mélange de chlorure de choline et d'au moins un composé HBD choisi parmi l'acide formique, l'urée et leur mélange, dans un rapport molaire chlorure de choline : HBD compris entre 0,2:2 et 5:2, notamment entre 0,5:2 et 1,5:2, voire entre 0,7:2 et 1,3:2, de préférence égal à 1:2 ;
de préférence le DES comprend, voire consiste en, un mélange de chlorure de choline et d'urée dans un rapport molaire chlorure de choline : urée compris entre 0,2:2 et 5:2, notamment entre 0,5:2 et 1,5:2, voire entre 0,7:2 et 1,3:2, de préférence égal à 1:2.

Selon un autre mode de réalisation particulier, le DES est hydrophobe, en particulier comprend, voire consiste en :
- au moins un composé HBA choisi parmi les monoterpénoïdes comportant au moins un groupe fonctionnel oxygéné et leurs mélanges, et
- au moins un composé HBD choisi parmi les acides monocarboxyliques aliphatiques non substitués, saturés ou insaturés, linéaires ou ramifiés, possédant de 6 à 20 atomes de carbone, l'acide lactique, l'acide 3-phenylpropionique, les acides dicarboxyliques hydrocarbonés non aromatiques, non substitués, saturés, linéaires ou ramifiés, possédant de 7 à 10 atomes de carbone, l'acide téréphtalique, la vanilline, la lidocaïne, le méthoxybenzène, l'eau, les composés de formule HR^{a}N-C(=X)-R^{d} (I), avec X étant choisi parmi un atome d'oxygène et un atome de soufre, R^{a} étant choisi parmi un atome d'hydrogène et un radical alkyle, linéaire ou ramifié, en C₁ à C₄, et R^{d} étant choisi parmi un radical alkyle, linéaire ou ramifié, en C₁ à C₄ et un radical -NR^{b}R^{c} avec R^{b} et R^{c} étant indépendamment l'un de l'autre choisis parmi un atome d'hydrogène et un radical alkyle, linéaire ou ramifié, en C₁ à C₄, et leurs mélanges ; plus particulièrement comprend, voire consiste en :
- au moins un composé HBA choisi parmi les monoterpénoïdes comportant au moins un groupe hydroxyle, les monoterpénoïdes comportant au moins un groupe carbonyle, et leurs mélanges, et

- au moins un composé HBD choisi parmi les acides monocarboxyliques aliphatiques saturés non substitués, linéaires ou ramifiés, possédant de 6 à 18 atomes de carbone, l'acide lactique, l'acide 3-phenylpropionique, l'acide azélaïque, l'acide téréphtalique, la vanilline, la lidocaïne, le méthoxybenzène, l'eau, les composés de formule HR^{a}N-C(=O)-NR^{b}R^{c} (I') avec R^{a}, R^{b} et R^{c} étant indépendamment les uns des autres choisis parmi un atome d'hydrogène et un radical alkyle linéaire ou ramifié en C₁ à C₄, et leurs mélanges ;

notamment comprend, voire consiste en :
   - le thymol à titre de composé HBA, et
   - au moins un composé HBD choisi parmi l'acide hexanoïque, l'acide heptanoïque, l'acide octanoïque, l'acide décanoïque, l'acide dodécanoïque, l'acide lactique, l'acide 3-phenylpropionique, l'acide azélaïque, l'acide téréphtalique, la vanilline, la lidocaïne, le méthoxybenzène, l'eau, l'urée et leurs mélanges,
de préférence, le DES comprend, voire consiste en, le thymol et au moins un composé HBD choisi parmi l'acide octanoïque, l'acide décanoïque, l'acide dodécanoïque, l'acide lactique, l'eau et leurs mélanges,
plus préférentiellement le DES comprend, voire consiste en, le thymol et au moins un composé HBD choisi parmi l'acide décanoïque, l'acide lactique, l'eau et leurs mélanges, en particulier, le DES comprend, voire consiste en, le thymol et au moins un composé HBD choisi parmi l'acide décanoïque et l'acide lactique.

Selon un mode de réalisation préféré, le DES comprend, voire consiste en, le thymol et l'acide décanoïque.

Selon un autre mode de réalisation préféré, le DES comprend, voire consiste en, le thymol et l'acide lactique.

Selon un autre mode de réalisation préféré, le DES comprend, voire consiste en, le thymol et l'eau.

En particulier, le DES est un DES hydrophobe comprenant, voire consistant en :
- un mélange d'un composé HBA choisi parmi les monoterpénoïdes comportant au moins un groupe hydroxyle, les monoterpénoïdes comportant au moins un groupe carbonyle, et leurs mélanges et d'un composé HBD choisi parmi les acides monocarboxyliques aliphatiques saturés non substitués, linéaires ou ramifiés, possédant de 6 à 18 atomes de carbone, l'acide lactique, l'acide 3-phenylpropionique, l'acide téréphtalique, la vanilline, la lidocaïne, le méthoxybenzène, et leurs mélanges, dans un rapport molaire HBA : HBD compris entre 0,2:1 et 5:1, notamment entre 0,5:1 et 1,5:1, voire entre 0,7:1 et 1,3:1, de préférence égal à 1:1 ;
- un mélange d'un composé HBA choisi parmi les monoterpénoïdes comportant au moins un groupe hydroxyle, les monoterpénoïdes comportant au moins un groupe carbonyle, et leurs mélanges et d'un composé HBD choisi parmi l'acide décanoïque, l'acide lactique, l'acide azélaïque, l'acide téréphtalique et leurs mélanges, dans un rapport molaire HBA : HBD compris entre 1:1 et 4:1, notamment entre 1,5:1 et 2,5:1, voire entre 1,7:1 et 2,3:1, de préférence égal à 2:1 ;
- un mélange d'un composé HBA choisi parmi les monoterpénoïdes comportant au moins un groupe hydroxyle, les monoterpénoïdes comportant au moins un groupe carbonyle, et leurs mélanges et d'acide décanoïque, dans un rapport molaire HBA : acide décanoïque compris entre 2:1 et 4:1, notamment entre 2,5:1 et 3,5:1, voire entre 2,7:1 et 3,3:1, de préférence égal à 3:1 ;
- un mélange d'un composé HBA choisi parmi les monoterpénoïdes comportant au moins un groupe hydroxyle, les monoterpénoïdes comportant au moins un groupe carbonyle, et leurs mélanges et d'un composé HBD choisi parmi l'acide décanoïque, l'acide lactique, l'acide téréphtalique, l'urée et leurs mélanges, dans un rapport molaire HBA : HBD compris entre 2:1 et 10:1, notamment entre 4:1 et 6:1, voire entre 4,5:1 et 5,5:1, de préférence égal à 5:1 ;
- un mélange d'un composé HBA choisi parmi les monoterpénoïdes comportant au moins un groupe hydroxyle, les monoterpénoïdes comportant au moins un groupe carbonyle, et leurs mélanges et d'eau, dans un rapport molaire HBA : eau compris entre 2:1 et 10:1, notamment entre 4:1 et 6:1, voire entre 4,3:1 et 5,3:1, de préférence égal à 4,8:1 ; ou
- un mélange d'un composé HBA choisi parmi les monoterpénoïdes comportant au moins un groupe hydroxyle, les monoterpénoïdes comportant au moins un groupe carbonyle, et leurs mélanges et d'acide lactique, dans un rapport molaire HBA : acide lactique compris entre 7:1 et 13:1, notamment entre 9:1 et 11:1, voire entre 9,5:1 et 10,5:1, de préférence égal à 10:1 ;

notamment peut comprendre, voire consister en :
   - un mélange de thymol et d'un composé HBD choisi parmi l'acide hexanoïque, l'acide heptanoïque, l'acide octanoïque, l'acide décanoïque, l'acide dodécanoïque, l'acide lactique, l'acide 3-phenylpropionique, l'acide téréphtalique, la vanilline, la lidocaïne, le méthoxybenzène, et leurs mélanges, dans un rapport molaire thymol : HBD compris entre 0,2:1 et 5:1, notamment entre 0,5:1 et 1,5:1, voire entre 0,7:1 et 1,3:1, de préférence égal à 1:1 ;
   - un mélange de thymol et d'un composé HBD choisi parmi l'acide décanoïque, l'acide lactique, l'acide azélaïque, l'acide téréphtalique et leurs mélanges, dans un rapport molaire thymol : HBD compris entre 1:1 et 4:1, notamment entre 1,5:1 et 2,5:1, voire entre 1,7:1 et 2,3:1, de préférence égal à 2:1 ;
   - un mélange de thymol et d'acide décanoïque, dans un rapport molaire thymol : acide décanoïque compris entre 2:1 et 4:1, notamment entre 2,5:1 et 3,5:1, voire entre 2,7:1 et 3,3:1, de préférence égal à 3:1 ;
   - un mélange de thymol et d'un composé HBD choisi parmi l'acide décanoïque, l'acide lactique, l'acide téréphtalique, l'urée et leurs mélanges, dans un rapport molaire thymol : HBD compris entre 2:1 et 10:1, notamment entre 4:1 et 6:1, voire entre 4,5:1 et 5,5:1, de préférence égal à 5:1 ;
   - un mélange de thymol et d'eau, dans un rapport molaire thymol : eau compris entre 2:1 et 10:1, notamment entre 4:1 et 6:1, voire entre 4,3:1 et 5,3:1, de préférence égal à 4,8:1 ; ou
   - un mélange de thymol et d'acide lactique, dans un rapport molaire thymol : acide lactique compris entre 7:1 et 13:1, notamment entre 9:1 et 11:1, voire entre 9,5:1 et 10,5:1, de préférence égal à 10:1 ;
de préférence, le DES comprend, voire consiste en :
   - un mélange de thymol et d'acide décanoïque, dans un rapport molaire thymol : acide décanoïque compris entre 0,2:1 et 5:1, notamment entre 0,5:1 et 1,5:1, voire entre 0,7:1 et 1,3:1 de préférence égal à 1:1 ;
   - un mélange de thymol et d'acide lactique, dans un rapport molaire thymol : acide lactique compris entre 1:1 et 4:1, notamment entre 1,5:1 et 2,5:1, voire entre 1,7:1 et 2,3:1, de préférence égal à 2:1 ; ou
   - un mélange de thymol et d'eau, dans un rapport molaire thymol : eau compris entre 2:1 et 10:1, notamment entre 4:1 et 6:1, voire entre 4,3:1 et 5,3:1, de préférence égal à 4,8:1.

En particulier, le DES comprend, voire consiste en :
- un mélange de thymol et d'acide décanoïque, dans un rapport molaire thymol : acide décanoïque compris entre 0,2:1 et 5:1, notamment entre 0,5:1 et 1,5:1, voire entre 0,7:1 et 1,3:1 de préférence égal à 1:1 ; ou
- un mélange de thymol et d'acide lactique, dans un rapport molaire thymol : acide lactique compris entre 1:1 et 4:1, notamment entre 1,5:1 et 2,5:1, voire entre 1,7:1 et 2,3:1, de préférence égal à 2:1.

Selon un mode de réalisation préféré, le DES comprend, voire consiste en, un mélange de thymol et d'acide décanoïque, dans un rapport molaire thymol : acide décanoïque compris entre 0,2:1 et 5:1, notamment entre 0,5:1 et 1,5:1, voire entre 0,7:1 et 1,3:1, de préférence égal à 1:1.

Selon un autre mode de réalisation préféré, le DES comprend, voire consiste en, un mélange de thymol et d'acide lactique, dans un rapport molaire thymol : acide lactique compris entre 1:1 et 4:1, notamment entre 1,5:1 et 2,5:1, voire entre 1,7:1 et 2,3:1, de préférence égal à 2:1. Selon un autre mode de réalisation préféré, le DES comprend, voire consiste en, un mélange de thymol et d'eau, dans un rapport molaire thymol : eau compris entre 2:1 et 10:1, notamment entre 4:1 et 6:1, voire entre 4,3:1 et 5,3:1, de préférence égal à 4,8:1.

Selon un mode de réalisation particulier, le DES comprend, voire consiste en :
- un mélange de chlorure de choline et d'urée dans un rapport molaire chlorure de choline : urée compris entre 0,2:2 et 5:2, notamment entre 0,5:2 et 1,5:2, voire entre 0,7:2 et 1,3:2, de préférence égal à 1:2 ;
- un mélange de thymol et d'acide décanoïque, dans un rapport molaire thymol : acide décanoïque compris entre 0,2:1 et 5:1, notamment entre 0,5:1 et 1,5:1, voire entre 0,7:1 et 1,3:1 de préférence égal à 1:1 ;
- un mélange de thymol et d'acide lactique, dans un rapport molaire thymol : acide lactique compris entre 1:1 et 4:1, notamment entre 1,5:1 et 2,5:1, voire entre 1,7:1 et 2,3:1, de préférence égal à 2:1 ; ou
- un mélange de thymol et d'eau, dans un rapport molaire thymol : eau compris entre 2:1 et 10:1, notamment entre 4:1 et 6:1, voire entre 4,3:1 et 5,3:1, de préférence égal à 4,8:1 ;
en particulier comprend, voire consiste en :
- un mélange de chlorure de choline et d'urée dans un rapport molaire chlorure de choline : urée compris entre 0,2:2 et 5:2, notamment entre 0,5:2 et 1,5:2, voire entre 0,7:2 et 1,3:2, de préférence égal à 1:2 ;
- un mélange de thymol et d'acide décanoïque, dans un rapport molaire thymol : acide décanoïque compris entre 0,2:1 et 5:1, notamment entre 0,5:1 et 1,5:1, voire entre 0,7:1 et 1,3:1 de préférence égal à 1:1 ; ou
- un mélange de thymol et d'acide lactique, dans un rapport molaire thymol : acide lactique compris entre 1:1 et 4:1, notamment entre 1,5:1 et 2,5:1, voire entre 1,7:1 et 2,3:1, de préférence égal à 2:1.

### Délamination de la feuille arrière

Comme indiqué précédemment, la mise en contact d'une feuille arrière de module photovoltaïque, notamment tel que décrite précédemment, avec un DES, notamment tel que décrit précédemment, permet de délaminer cette feuille arrière et de désolidariser les unes des autres, les couches qui la composent pour les récupérer.

Les conditions de mise en œuvre de l'étape b) telles que la température et la durée de mise en contact peuvent être adaptées en fonction du DES mis en œuvre.

L'étape b) peut être réalisée à une température supérieure ou égale à la température de fusion du DES.

L'étape b) peut être réalisée à une température allant de 0°C à 200°C.

L'étape b) peut être réalisée à une température d'au moins 70°C, plus particulièrement allant de 100°C à 200°C, voire de 130°C à 190°C. Ces gammes de températures peuvent notamment être mises en œuvre dans le cas d'un DES hydrophile, notamment choisi parmi les DES comprenant du chlorure de choline à titre de composé HBA.

L'étape b) peut aussi être réalisée à une température allant de 10°C à 100°C, en particulier de 20°C à 80°C, plus particulièrement de 60°C à 70°C. L'étape b) peut aussi être réalisée à une température allant de 20°C à 40°C. Ces gammes de températures peuvent notamment être mises en œuvre dans le cas d'un DES hydrophobe, en particulier comprenant du thymol à titre de composé HBA.

L'étape b) peut être réalisée pendant au moins 10 min, en particulier pendant 10 min à 10h, plus particulièrement pendant 30 min à 5h, voire pendant 1h à 4h.

Avantageusement, l'étape b) peut être conduite jusqu'à ce que la force d'adhésion soit réduite entre la couche fluorée et la couche intermédiaire, voire jusqu'à ce que ladite couche fluorée soit désolidarisée de ladite couche intermédiaire. En particulier, l'étape b) peut être réalisée à une température allant de 100°C à 200°C pendant 10 min à 10h, notamment pendant 1h à 5h, en particulier avec un DES hydrophile, notamment choisi parmi les DES comprenant du chlorure de choline à titre de composé HBA. En variante, l'étape b) peut être réalisée à une température allant de 100°C à 200°C pendant 10 min à 10h, notamment pendant 1h à 5h, en particulier avec un DES hydrophobe, notamment choisi parmi les DES comprenant du thymol à titre de composé HBA. L'étape b) peut aussi être réalisée à une à une température allant de 60°C à 70°C pendant 10 min à 10h, notamment pendant 1h à 5h, ou encore à une température allant de 20°C à 40°C pendant au moins 2 jours, notamment pendant 5 jours à deux semaines, en particulier avec un DES hydrophobe, notamment choisi parmi les DES comprenant du thymol à titre de composé HBA.

L'étape b) peut être réalisée par immersion de la feuille arrière dans le DES, en particulier sous agitation, par exemple sous agitation magnétique, mécanique ou à ultrasons.

La feuille arrière peut être mise en œuvre à l'étape b) à raison de 0,1% à 10% massique, en particulier de 0,5 à 5% massique, voire de 1 à 2% massique, par rapport à la masse totale de DES, en particulier avec un DES hydrophile.

La feuille arrière peut également être mise en œuvre à l'étape b) à raison de 30 à 50% massique, en particulier de 30 à 40% massique, par rapport à la masse totale de DES, en particulier avec un DES hydrophobe.

En particulier, les couches obtenues après l'étape b) peuvent être autoporteuses, c'est-à-dire qu'elles ne rompent pas sous l'effet de leur propre poids. En particulier, moins de 20% massique, notamment moins de 10% massique, voire moins de 5% massique, voire encore moins de 1% massique, voire même moins de 0,1% massique, des couches sont solubilisés dans le DES à l'issue de l'étape b). Avantageusement, les couches ne sont pas solubilisées dans le DES au cours de l'étape b).

De préférence, l'intégrité des couches de la feuille arrière est conservée au cours de l'étape b). Par exemples, les longueur, largeur et épaisseur desdites couches sont sensiblement identiques avant et après l'étape b), c'est-à-dire qu'elles n'ont pas varié de plus de 5%, notamment pas de plus de 1% par rapport aux longueur, largeur et épaisseur mesurées à l'étape a). Il est donc possible de s'affranchir d'étapes ultérieures de séparation.

Le procédé de délamination peut comprendre en outre à l'issue de l'étape b) la récupération de la couche fluorée désolidarisée des autres couches de la feuille arrière, en particulier la récupération de la couche fluorée et de la couche intermédiaire désolidarisées l'une de l'autre et le cas échéant désolidarisées des autres couches de la feuille arrière. En particulier, le procédé de délamination peut comprendre en outre à l'issue de l'étape b) la récupération de chacune des couches constitutives de la feuille arrière sous une forme désolidarisée les unes des autres.

Par exemple, lorsque la feuille arrière comporte une couche fluorée, une couche intermédiaire et une couche d'apprêt, la couche fluorée, la couche intermédiaire et la couche d'apprêt sont récupérées sous une forme désolidarisée les unes des autres.

Le procédé de délamination peut comprendre en outre le rinçage, notamment par mise en contact avec de l'eau et/ou de l'éthanol, des couches récupérées à l'issue de l'étape b). Les couches peuvent être en particulier séchées après rinçage, notamment à une température allant de 10°C à 100°C voire de 20°C à 50°C.

### Applications

Les couches récupérées à l'issue du procédé de délamination selon l'invention peuvent être recyclées indépendamment les unes des autres et/ou réutilisées indépendamment les unes des autres, notamment pour fabriquer une ou plusieurs nouvelles feuilles arrières.

De préférence, les couches récupérées peuvent subir au moins un traitement avant leur réutilisation.

### Exemple 1

### Feuille arrière

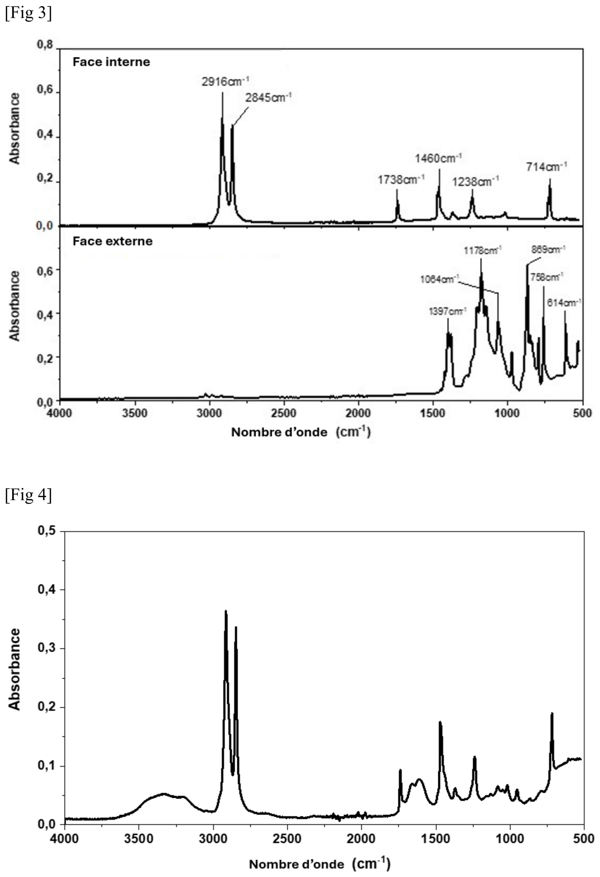

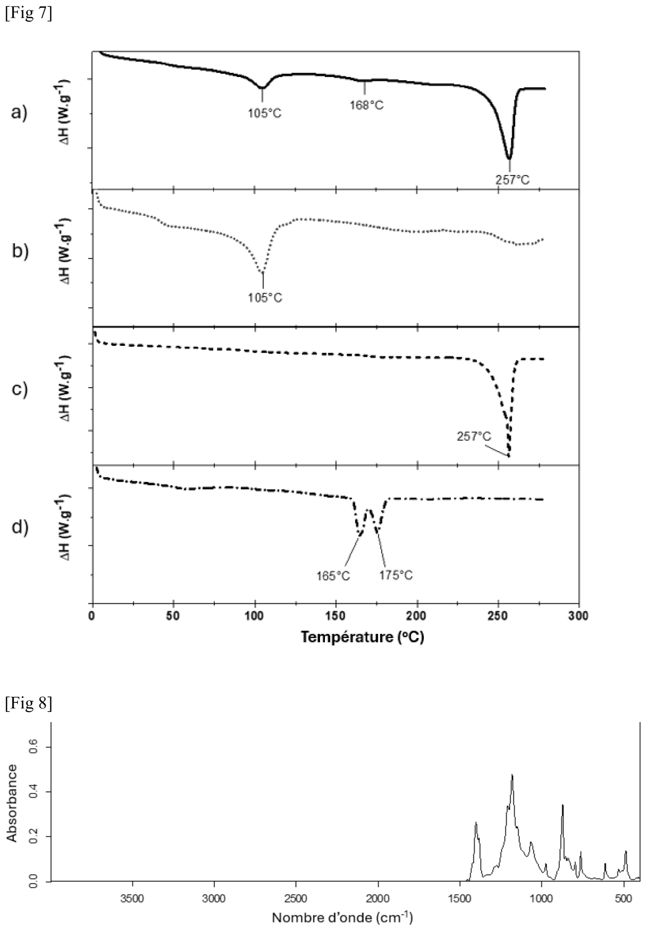

La feuille arrière de module photovoltaïque mise en œuvre dans cet exemple, représentée en figure 2, est un matériau tricouche polymérique dont l'épaisseur totale est de 380 µm, comportant la succession d'une couche de primer de type polyoléfine en PE, d'une couche intermédiaire en PET et d'une couche fluorée en PVDF. La feuille arrière est analysée préalablement au procédé de délamination par FTIR-ATR et DSC, dont les résultats sont représentés respectivement en figure 3 et en figure 7a et reportés en tableau 2. La face externe correspond au côté de la feuille arrière comportant la couche fluorée en PVDF, et la face interne correspond au côté de la feuille arrière comportant la couche de primer en PE.

### Délamination de feuilles arrières par le procédé selon l'invention avec un DES de type chlorure de choline : urée (1:2)

Du chlorure de choline et de l'urée sont mélangés à l'état fondu à 150 °C dans un rapport molaire chlorure de choline : urée égal à 1:2, jusqu'à obtention d'un mélange homogène. Le solvant eutectique profond obtenu est refroidi à température ambiante, c'est-à-dire à une température allant de 20°C à 30°C.

Après découpage, la feuille arrière sous la forme d'un échantillon de surface 10 x 6 mm² est pesé puis introduit dans un flacon contenant une masse connue de DES. Le mélange est ensuite porté à une température donnée pendant un temps déterminé conduisant à la désolidarisation des trois couches polymériques. La masse de feuille arrière et la masse de DES mis en contact, la température à laquelle le DES est porté et la durée de mise en contact de l'échantillon de feuille arrière avec le DES sont reportés dans le tableau 1 ci-après.

**[Tableau 1]**

| **Essai** | **Masse de DES (g)** | **Masse de feuille arrière (mg)** | **Température (°C)** | **Durée (h)** |
|---|---|---|---|---|
| **A** | **25** | **328** | **170** | **4** |
| **B** | **30** | **344** | **150** | **2** |

Les trois couches polymériques désolidarisées les unes des autres sont récupérées par filtration, rincées à l'eau, puis séchées à l'air ambient.

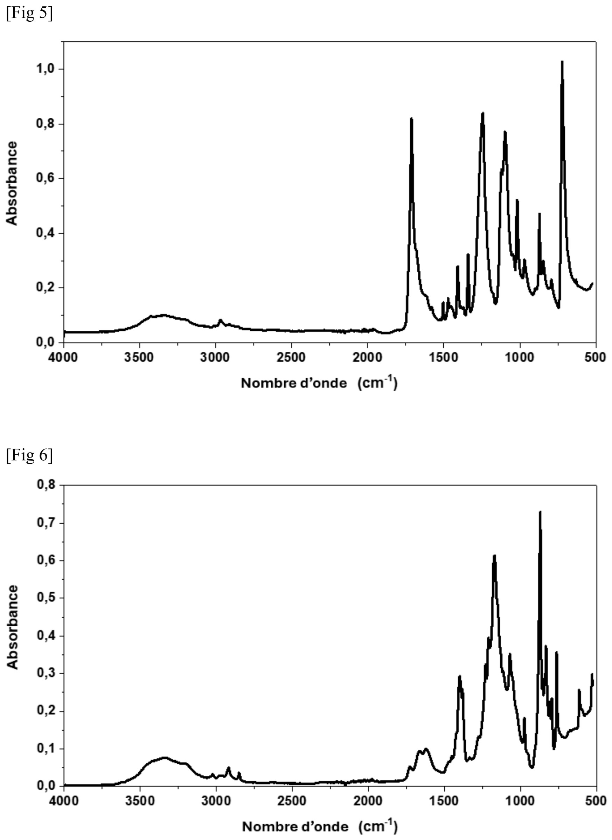

Après séchage, les trois couches obtenues sont analysées par FTIR-ATR. Les spectres obtenus par FTIR-ATR pour l'essai B sont représentés en figures 4, 5 et 6 respectivement pour la couche de primer, la couche intermédiaire en PET et la couche fluorée en PVDF. Ces spectres confirment pour les essais A et B que les couches récupérées comportent le polymère constitutif de ladite couche avec très peu voire pas d'impuretés provenant des autres couches.

Les trois couches obtenues sont également analysées par DSC. Les courbes obtenues par DSC pour l'essai B sont représentées en figures 7b), 7c) et 7d) respectivement pour la couche de primer, la couche intermédiaire en PET et la couche fluorée en PVDF. Les résultats sont également reportés dans le tableau 2 ci-après. Ils confirment que le procédé de l'invention permet de délaminer la feuille arrière et de désolidariser les couches polymériques les unes des autres avec peu voire pas de contamination par les autres couches.

**[Tableau 2]**

| **Essai** | **Polymères** | **Analyses DSC** |
|---|---|---|
| **Feuille arrière avant traitement** | **Tricouche Primer / PET / PVDF** | **Pic fusion Polyoléfine à 105 °C** |
| | | **Pic fusion PVDF à 167 °C** |
| | | **Pic de fusion PET à 260 °C** |
| **A après traitement** | **Couche de primer** | **Pic fusion Polyoléfine à 105 °C + traces de PET** |
| | **Couche de PET** | **Pic de fusion PET à 260 °C** |
| | **Couche de PVDF** | **Pic fusion PVDF à 167 °C + traces PET** |
| **B après traitement** | **Couche de primer** | **Pic fusion Polyoléfine à 105 °C** |
| | **Couche de PET** | **Pic de fusion PET à 260 °C** |
| | **Couche de PVDF** | **Pic fusion PVDF à 167 °C** |

### Exemple 2

### Feuille arrière

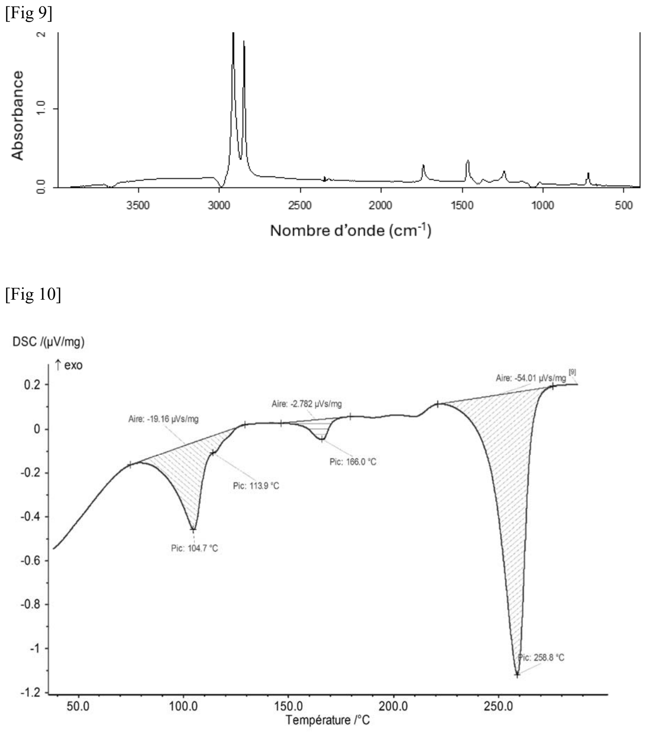

La feuille arrière de module photovoltaïque mise en œuvre dans cet exemple est telle que décrite en exemple 1. La feuille arrière est analysée préalablement au procédé de délamination par FTIR-ATR et DSC. Les résultats de FTIR-ATR sont représentés en figure 8 pour la face externe correspondant au côté de la feuille arrière comportant la couche fluorée en PVDF, et en figure 9 pour la face interne correspondant au côté de la feuille arrière comportant la couche de primer en PE. Les résultats de DSC sont représentés en figure 10.

### Délamination de feuilles arrières par le procédé selon l'invention

### 2.1. Délamination avec un DES de type thymol : acide décanoïque (1:1)

Du thymol et de l'acide décanoïque sont mélangés à l'état fondu à 110°C dans un rapport molaire thymol : acide décanoïque égal à 1:1, jusqu'à obtention d'un mélange homogène. Le solvant eutectique profond obtenu est conservé à température ambiante, entre 20 et 30°C. Après découpage, 1,2 g de feuille arrière sous la forme d'une éprouvette de traction iso S27-2-5A (5 cm de longueur pour 1 cm de large)est pesé puis introduit dans un flacon contenant de 2 à 2,5 g de DES. Le mélange est ensuite porté à une température entre 60 et 70°C pendant 4 h conduisant à la désolidarisation des trois couches polymériques.

Les trois couches polymériques désolidarisées les unes des autres sont récupérées par filtration, rincées à l'éthanol, puis séchées à l'air ambient.

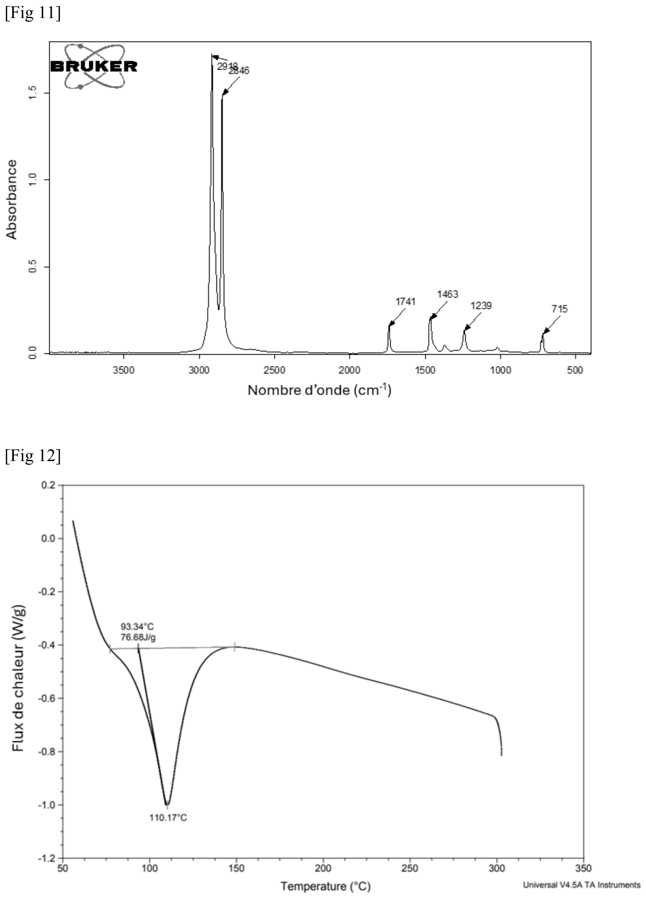

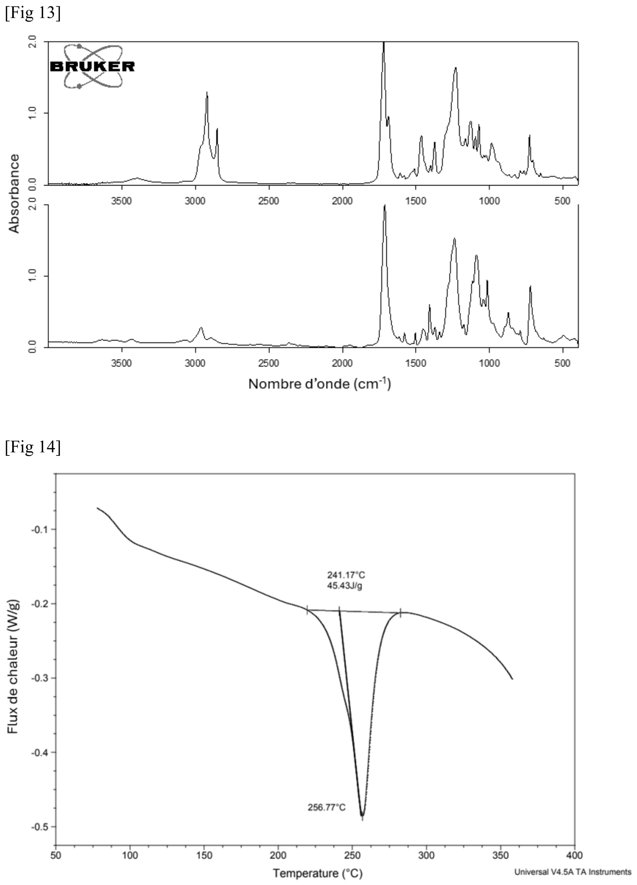

Après séchage, les trois couches obtenues sont analysées par FTIR-ATR. Les spectres obtenus par FTIR-ATR sont représentés en figures 11, 13 (haut) et 15 (haut) respectivement pour la couche de primer en PE, la couche intermédiaire en PET et la couche fluorée en PVDF. Les figures 13 (bas) et 15 (bas) représentent également le spectre FTIR-ATR obtenu respectivement pour un PET commercial et un PVDF commercial. Ces spectres confirment que les couches récupérées comportent le polymère constitutif de ladite couche avec très peu voire pas d'impuretés provenant des autres couches.

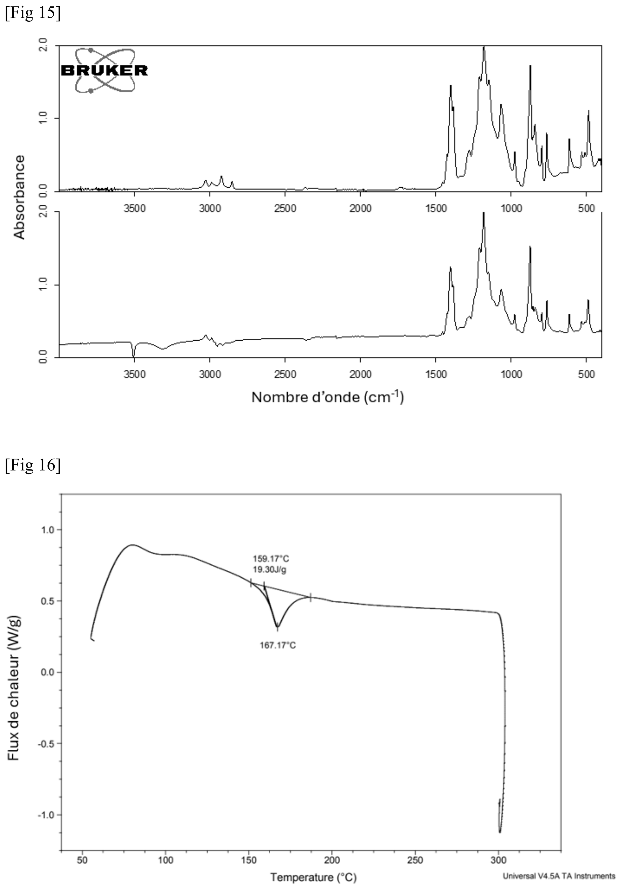

Les trois couches obtenues sont également analysées par DSC. Les courbes obtenues par DSC sont représentées en figures 12, 14 et 16 respectivement pour la couche de primer, la couche intermédiaire en PET et la couche fluorée en PVDF et confirment que le procédé de l'invention permet de délaminer la feuille arrière et de désolidariser les couches polymériques les unes des autres avec peu voire pas de contamination par les autres couches. Des mesures mécaniques ont également été réalisées et démontrent d'une part que la qualité du polymère de la couche de primer, de la couche intermédiaire et/ou de la couche fluorée après séparation est propice au recyclage, et d'autre part que le procédé n'entraine pas de dégradation des couches.

### 2.2. Délamination avec un DES de type thymol : acide lactique (2:1)

Du thymol et de l'acide lactique sont mélangés à l'état fondu à 110°C dans un rapport molaire thymol : acide lactique égal à 2:1, jusqu'à obtention d'un mélange homogène. Le solvant eutectique profond obtenu est refroidi à température ambiante, entre 20 et 30°C. Après découpage, 1,2 g de feuille arrière sous la forme d'une éprouvette de traction iso S27-2-5A (5 cm de longueur pour 1 cm de large) est pesé puis introduit dans un flacon contenant 2,5 g de DES. Le mélange est ensuite porté à une température de 70°C pendant 2h conduisant à la désolidarisation des trois couches polymériques.

Les trois couches polymériques désolidarisées les unes des autres sont récupérées par filtration, rincées à l'eau, puis séchées à l'air ambient.

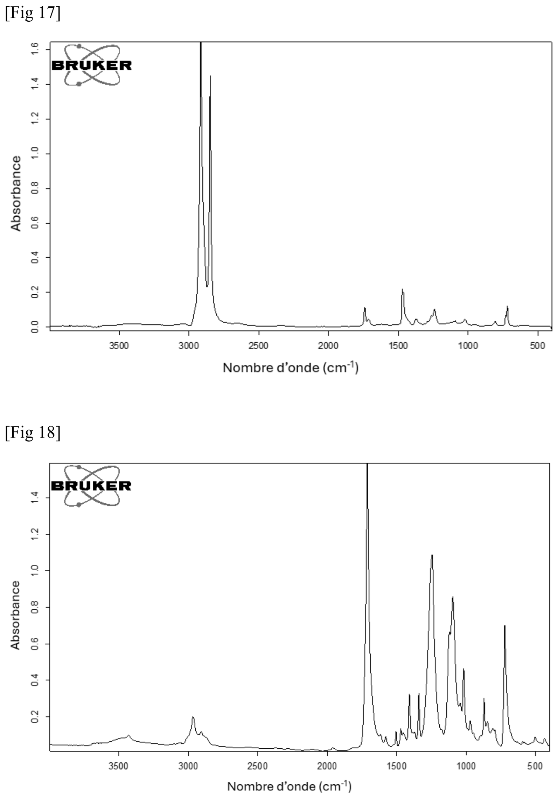

Après séchage, les trois couches obtenues sont analysées par FTIR-ATR. Les spectres obtenus par FTIR-ATR sont représentés en figures 17, 18 et 19 respectivement pour la couche de primer en PE, la couche intermédiaire en PET et la couche fluorée en PVDF. Ces spectres confirment que les couches récupérées comportent le polymère constitutif de ladite couche avec très peu voire pas d'impuretés provenant des autres couches.

### Exemple 3

### Feuille arrière

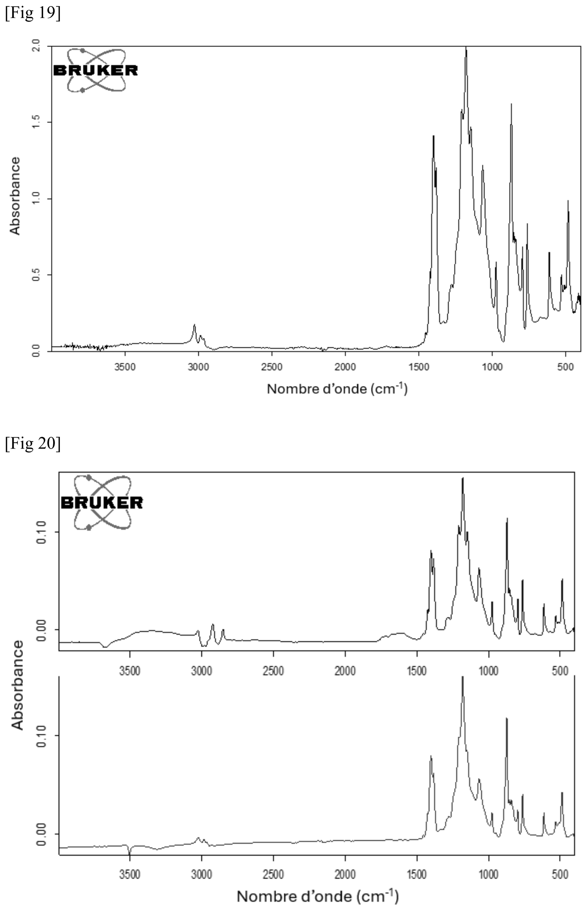

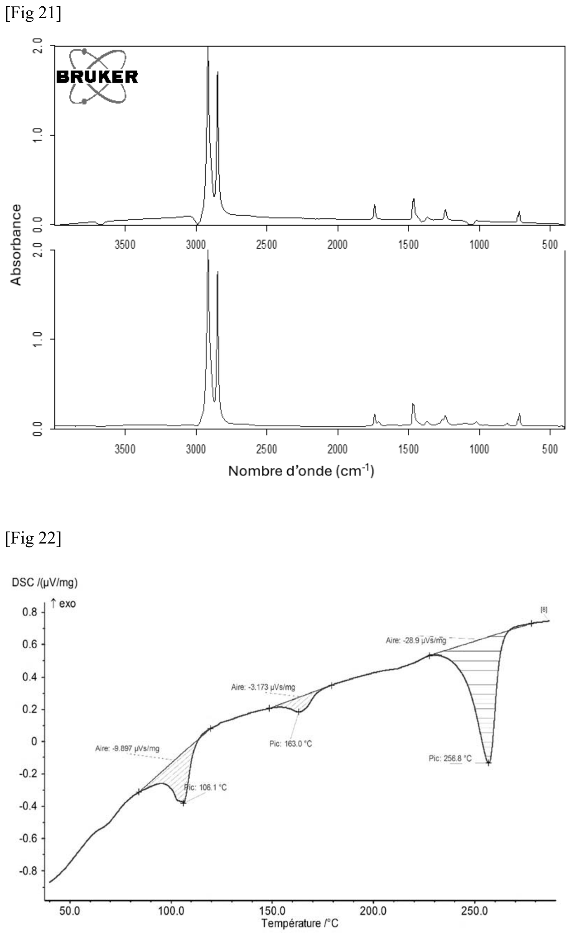

La feuille arrière de module photovoltaïque mise en œuvre dans cet exemple est un matériau comportant la succession d'une couche de primer de type polyoléfine en PE, d'une couche intermédiaire en PET, d'une couche d'aluminium et d'une couche fluorée en PVDF. La feuille arrière est analysée préalablement au procédé de délamination par FTIR-ATR et DSC. Les résultats de FTIR-ATR sont représentés en figure 20 (haut) pour la face externe correspondant au côté de la feuille arrière comportant la couche fluorée en PVDF, et en figure 21 (haut) pour la face interne correspondant au côté de la feuille arrière comportant la couche de primer en PE. Les figures 20 (bas) et 21 (bas) représentent également le spectre FTIR-ATR obtenu respectivement pour un PVDF commercial et un PET commercial. Les résultats de DSC sont représentés en figure 22.

### Délamination de feuilles arrières par le procédé selon l'invention avec un DES de type thymol : acide décanoïque (1:1)

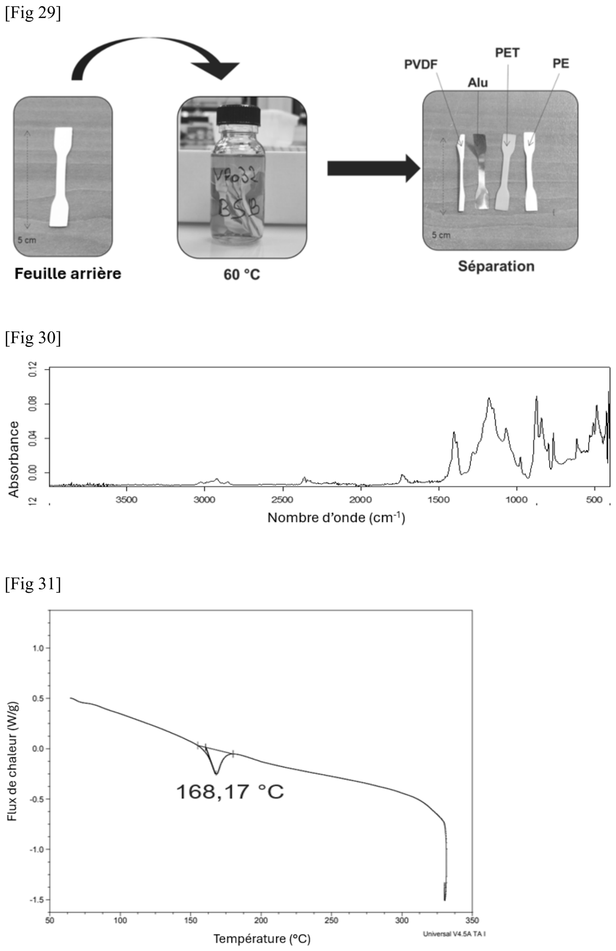

Un DES à base de thymol et d'acide décanoïque est préparé comme détaillé en exemple 2.1. Après découpage, 1,2 g de feuille arrière sous la forme d'une éprouvette de traction iso S27-2-5A (5 cm de longueur pour 1 cm de large), illustrée en figure 29 (à gauche) est pesé puis introduit dans un flacon contenant 2,5 g de DES. Le mélange est ensuite porté à une température de 70°C pendant 2h, comme illustré en figure 29 (milieu) conduisant à la désolidarisation des quatre couches.

Les quatre couches désolidarisées les unes des autres sont récupérées par filtration, rincées à l'éthanol, puis séchées à l'air ambient. Les couches récupérées sont illustrées en figure 29 (à droite).

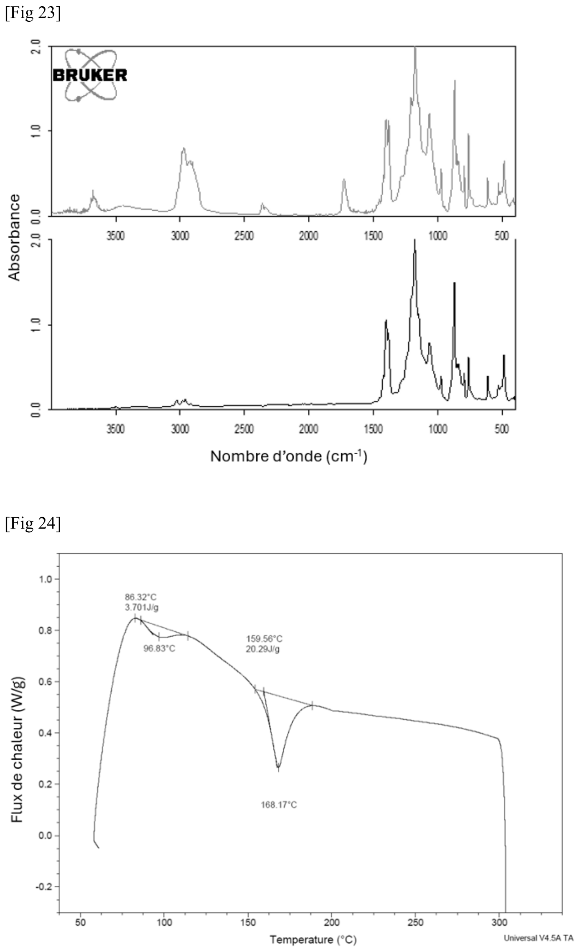

Après séchage, les couches polymériques obtenues sont analysées par FTIR-ATR. Les spectres obtenus par FTIR-ATR sont représentés en figures 23 (haut), 25 (haut) et 27 respectivement pour la couche fluorée en PVDF, la couche de primer en PE et la couche intermédiaire en PET. Les figures 23 (bas) et 25 (bas) représentent également le spectre FTIR-ATR obtenu respectivement pour un PVDF commercial et un PE commercial. Ces spectres confirment que les couches récupérées comportent le polymère constitutif de ladite couche avec très peu voire pas d'impuretés provenant des autres couches.

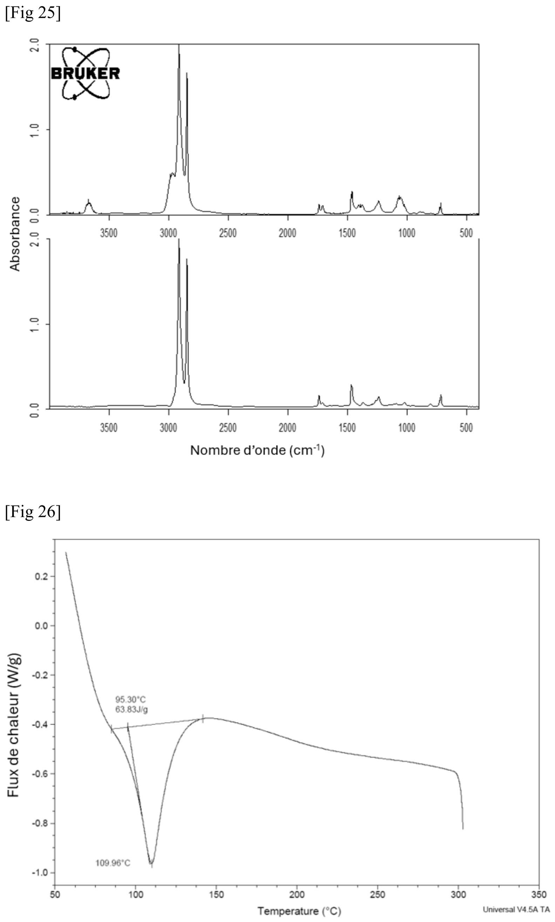

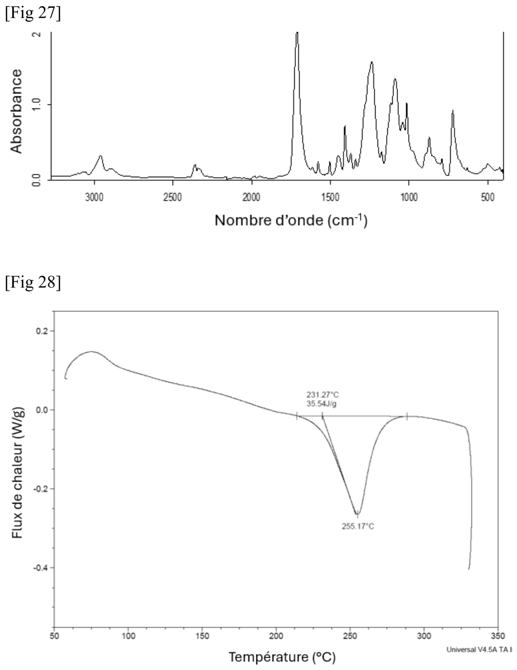

Les couches polymériques obtenues sont également analysées par DSC. Les courbes obtenues par DSC sont représentées en figures 24, 26 et 28 respectivement pour la couche fluorée en PVDF, la couche de primer en PE et la couche intermédiaire en PET et confirment que le procédé de l'invention permet de délaminer la feuille arrière et de désolidariser les couches polymériques les unes des autres avec peu voire pas de contamination par les autres couches.

Des mesures mécaniques ont également été réalisées et démontrent d'une part que la qualité du polymère de la couche de primer, de la couche intermédiaire et de la couche fluorée après séparation est propice au recyclage, et d'autre part que le procédé n'entraine pas de dégradation des couches.

### Exemple 4

### Feuille arrière

La feuille arrière de module photovoltaïque mise en œuvre dans cet exemple est une feuille arrière de modèle FP 215 : IP200 commercialisé par Fonroche, vieillie par utilisation dans un module photovoltaïque pendant de 20 ans, et comportant la succession d'une première couche fluorée en PVDF, d'une couche intermédiaire en PET et d'une seconde couche fluorée en PVDF.

### Délamination de feuilles arrières par le procédé selon l'invention avec un DES de type thymol : acide décanoïque (1:1)

Un DES à base de thymol et d'acide décanoïque est préparé comme détaillé en exemple 2.1. Après découpage, 1,2 g de feuille arrière sous la forme d'une éprouvette de traction iso S27-2-5A (5 cm de longueur pour 1 cm de large) est pesé puis introduit dans un flacon contenant 2 g de DES. Le mélange est ensuite porté à une température de 70°C pendant 2h, conduisant à la désolidarisation des trois couches.

Les couches désolidarisées les unes des autres sont récupérées par filtration, rincées à l'éthanol, puis séchées à l'air ambient.

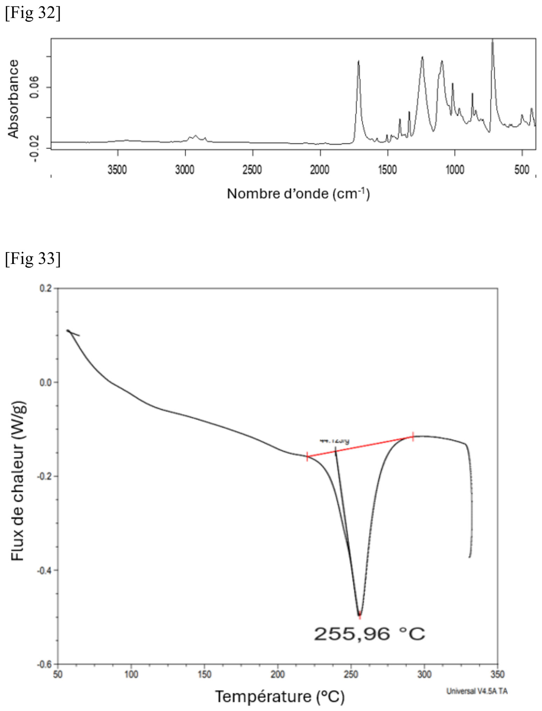

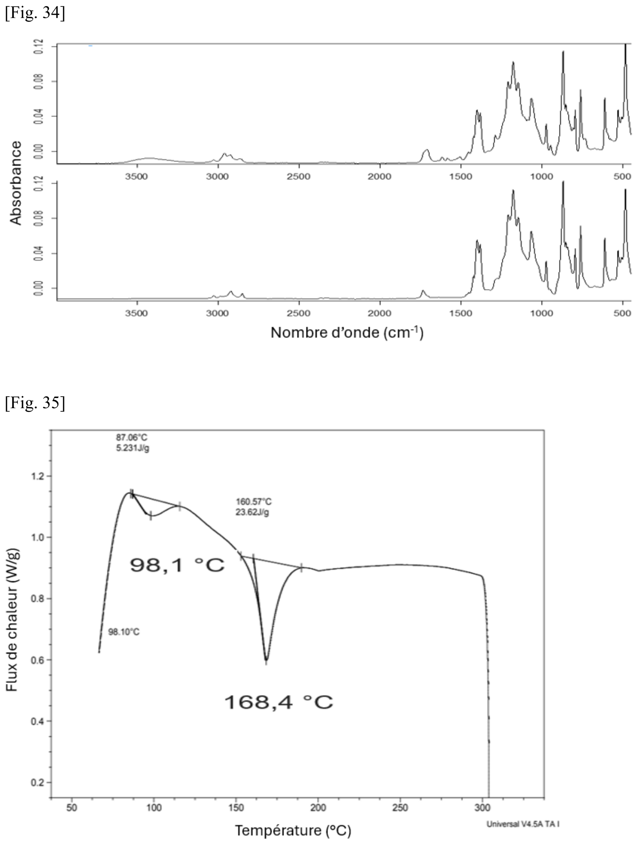

Après séchage, les couches polymériques obtenues sont analysées par FTIR-ATR. Les spectres obtenus par FTIR-ATR sont représentés en figures 30, 32 et 34 respectivement pour la première couche fluorée en PVDF, la couche intermédiaire en PET et les deux faces nommées A et B de la seconde couche en PVDF. Ces spectres confirment que les couches récupérées comportent le polymère constitutif de ladite couche avec très peu voire pas d'impuretés provenant des autres couches.

Les couches polymériques obtenues sont également analysées par DSC. Les courbes obtenues par DSC sont représentées en figures 31, 33 et 35 respectivement pour la première couche fluorée en PVDF, la couche intermédiaire en PET et la seconde couche en PVDF. Elles confirment que le procédé de l'invention permet de délaminer la feuille arrière et de désolidariser les couches polymériques les unes des autres avec peu voire pas de contamination par les autres couches.

### Liste des documents cités

[1] Morita et al., J. of Mater. Cycles & Waste Management, 25:674-683 (2023).
[2] Rubino et al., Waste Management, 122, 89-99 (2021).
[3] Camargo et al., Detritus, 16, 48-62 (2021).
[4] Makoś*et al.,* Microchemical Journal, Vol. 152 (2020).

## Revendications

1. Procédé de délamination d'une feuille arrière multicouche de module photovoltaïque, comprenant au moins les étapes consistant à :
a) Disposer d'au moins une feuille arrière multicouche de module photovoltaïque,
la feuille arrière comportant :
- au moins une couche fluorée comprenant au moins un polymère fluoré, et
- au moins une couche, dite couche intermédiaire, comprenant au moins un polymère choisi parmi le polytéréphtalate d'éthylène (PET), le polytéréphtalate de triméthylène (PTT), le polytéréphtalate de butylène (PBT), le polynaphtalate d'éthylène (PEN), les polyéthercétones (PEK), les polyaryléthercétones (PAEK), les polyétherimides (PEI) et leurs mélanges ;
b) Délaminer ladite feuille arrière au contact d'au moins un solvant eutectique profond, dit DES, le DES étant de préférence hydrophobe, en particulier non ionique.

2. Procédé selon la revendication 1, la feuille arrière comportant en outre au moins une couche d'apprêt polymérique, la couche d'apprêt comprenant en particulier au moins un polymère choisi parmi les polyoléfines, l'éthylène-acétate de vinyle, les copolymères d'éthylène-propylène-diène (EPDM), le polyfluorure de vinyle (PVF), le polyfluorure de vinylidène (PVDF) et leurs mélanges, plus particulièrement parmi les polyoléfines, le polyfluorure de vinyle (PVF), le polyfluorure de vinylidène (PVDF) et leurs mélanges, notamment parmi les polyoléfines, voire comprenant au moins le polyéthylène.

3. Procédé selon la revendication 1 ou 2, le polymère fluoré étant choisi parmi les homopolymères et les copolymères formés à partir d'au moins un monomère choisi parmi le fluorure de vinyle, le fluorure de vinylidène et le tétrafluoroéthylène dont l'un des atomes de fluor peut être remplacé par un atome de chlore ou un groupement CF₃, et leurs mélanges, en particulier parmi le polyfluorure de vinyle (PVF), le polyfluorure de vinylidène (PVDF), le polytétrafluoroéthylène (PTFE), le copolymère de fluoroéthylène et d'éther vinylique (FEVE), le copolymère de tétrafluoroéthylène, d'hexafluoropropylène et de fluorure de vinylidène (THV), le poly(éthylène-co-tétrafluoroéthylène) (ETFE), le poly(ethylène-co-chlorotrifluoroéthylène) (ECTFE), et leurs mélanges, plus particulièrement parmi le polyfluorure de vinyle (PVF), le polyfluorure de vinylidène (PVDF) et leur mélange, notamment le polymère fluoré étant le polyfluorure de vinylidène (PVDF).

4. Procédé selon l'une quelconque des revendications précédentes, la couche intermédiaire comprenant au moins un polymère choisi parmi le polytéréphtalate d'éthylène (PET), le polytéréphtalate de triméthylène (PTT), le polytéréphtalate de butylène (PBT) et leurs mélanges, en particulier parmi le polytéréphtalate d'éthylène (PET), le polytéréphtalate de butylène (PBT) et leur mélange, plus particulièrement comprenant au moins le polytéréphtalate d'éthylène (PET).

5. Procédé selon l'une quelconque des revendications précédentes, le DES comprenant au moins un composé accepteur de liaison hydrogène (HBA) choisi parmi :
- les sels halogénés d'ammonium, de phosphonium ou de sulfonium et leurs mélanges, et
- les monoterpénoïdes comportant au moins un groupe fonctionnel oxygéné et leurs mélanges ;
en particulier parmi :
- les chlorures d'ammonium quaternaire, les bromures d'ammonium quaternaire et leurs mélanges, et
- les monoterpénoïdes comportant au moins un groupe hydroxyle, les monoterpénoïdes comportant au moins un groupe carbonyle, les monoterpénoïdes comportant au moins un groupe éther cyclique et leurs mélanges ;
plus particulièrement choisi parmi :
- le chlorure de choline, le chlorure de N-éthyl-2-hydroxy-N,N-diméthyléthanaminium, le chlorure de 2-(chlorocarbonyloxy)-N,N,N-triméthyl-ethanaminium, le chlorure de N-benzyl-2-hydroxy-N,N-diméthyléthanaminium et leurs mélanges, et
- la carvone, l'eucalyptol, le thymol et leurs mélanges,
notamment choisi parmi le chlorure de choline et le thymol, de préférence le DES comprenant au moins le thymol à titre de composé HBA.

6. Procédé selon l'une quelconque des revendications précédentes, le DES comprenant au moins un composé donneur de liaison hydrogène (HBD) choisi parmi :
- les acides monocarboxyliques aliphatiques non substitués, saturés ou insaturés, linéaires ou ramifiés, possédant de 6 à 20 atomes de carbone,
- les acides dicarboxyliques hydrocarbonés non aromatiques, non substitués, saturés, linéaires ou ramifiés, possédant de 2 à 10 atomes de carbone,
- l'acide formique, l'acide lactique, l'acide téréphtalique, l'acide 3-phénylpropionique, l'acide citrique,
- les composés de formule HR^{a}N-C(=X)-R^{d} (I), avec X étant choisi parmi un atome d'oxygène et un atome de soufre, R^{a} étant choisi parmi un atome d'hydrogène et un radical alkyle linéaire ou ramifié en C₁ à C₄, et R^{d} étant choisi parmi un radical alkyle linéaire ou ramifié en C₁ à C₄, et un radical -NR^{b}R^{c} avec R^{b} et R^{c} étant indépendamment l'un de l'autre choisis parmi un atome d'hydrogène et un radical alkyle linéaire ou ramifié en C₁ à C₄,
- la vanilline, la lidocaïne, le méthoxybenzène,
- l'eau,
et leurs mélanges,
en particulier parmi :
- les acides monocarboxyliques aliphatiques saturés non substitués, linéaires ou ramifiés, possédant de 6 à 18 atomes de carbone,
- l'acide lactique,
- les composés de formule HR^{a}N-C(=O)-NR^{b}R^{c} (I') avec R^{a}, R^{b} et R^{c} étant indépendamment les uns des autres choisis parmi un atome d'hydrogène et un radical alkyle linéaire ou ramifié en C₁ à C₄,
- l'eau,
et leurs mélanges,
plus particulièrement parmi :
- les acides monocarboxyliques aliphatiques saturés non substitués, linéaires ou ramifiés, possédant de 6 à 18 atomes de carbone,
- l'acide lactique,
- les composés de formule HR^{a}N-C(=O)-NR^{b}R^{c} (I') avec R^{a}, R^{b} et R^{c} étant indépendamment les uns des autres choisis parmi un atome d'hydrogène et un radical alkyle linéaire ou ramifié en C₁ à C₄,
et leurs mélanges,
plus particulièrement parmi l'acide lactique, l'acide hexanoïque, l'acide heptanoïque, l'acide octanoïque, l'acide décanoïque, l'acide dodécanoïque, l'urée et leurs mélanges, notamment parmi l'acide lactique, l'acide décanoïque, l'urée et leurs mélanges,
de préférence le DES comprenant au moins l'acide lactique ou l'acide décanoïque à titre de composé HBD.

7. Procédé selon l'une quelconque des revendications précédentes, le DES étant hydrophile, en particulier comprenant, voire consistant en :
- au moins un composé HBA choisi parmi les sels halogénés d'ammonium, de phosphonium ou de sulfonium, et leurs mélanges, et
- au moins un composé HBD choisi parmi les acides dicarboxyliques hydrocarbonés non aromatiques, non substitués, saturés, linéaires ou ramifiés, possédant de 2 à 10 atomes de carbone, l'acide citrique, l'acide formique, les composés de formule HR^{a}N-C(=X)-R^{d} (I), avec X étant choisi parmi un atome d'oxygène et un atome de soufre, R^{a} étant choisi parmi un atome d'hydrogène et un radical alkyle, linéaire ou ramifié, en C₁ à C₄, et R^{d} étant choisi parmi un radical alkyle, linéaire ou ramifié, en C₁ à C₄ et un radical -NR^{b}R^{c} avec R^{b} et R^{c} étant indépendamment l'un de l'autre choisis parmi un atome d'hydrogène et un radical alkyle, linéaire ou ramifié, en C₁ à C₄, et leurs mélanges ;
plus particulièrement comprenant, voire consistant en :
- un mélange d'un composé HBA choisi parmi les chlorures d'ammonium quaternaire, les bromures d'ammonium quaternaire et leurs mélanges, et d'un composé HBD choisi parmi les acides dicarboxyliques hydrocarbonés non aromatiques, non substitués, saturés et linéaires, possédant de 2 à 8 atomes de carbone, l'acide citrique et leurs mélanges, dans un rapport molaire HBA : HBD compris entre 0,2:1 et 5:1, notamment entre 0,5:1 et 1,5:1, voire entre 0,7:1 et 1,3:1, de préférence égal à 1:1 ; ou
- un mélange d'un composé HBA choisi parmi les chlorures d'ammonium quaternaire, les bromures d'ammonium quaternaire et leurs mélanges, et d'un composé HBD choisi parmi l'acide formique, les composés de formule HR^{a}N-C(=O)-NR^{b}R^{c} (I') avec R^{a}, R^{b} et R^{c} étant indépendamment les uns des autres choisis parmi un atome d'hydrogène et un radical alkyle, linéaire ou ramifié, en C₁ à C₄, et leurs mélanges, dans un rapport molaire HBA : HBD compris entre 0,2:2 et 5:2, notamment entre 0,5:2 et 1,5:2, voire entre 0,7:2 et 1,3:2, de préférence égal à 1:2 ;
notamment comprenant, voire consistant en :
- un mélange de chlorure de choline et d'au moins un composé HBD choisi parmi l'acide oxalique, l'acide malonique, l'acide succinique, l'acide adipique, l'acide citrique et leurs mélanges, dans un rapport molaire chlorure de choline : HBD compris entre 0,2:1 et 5:1, notamment entre 0,5:1 et 1,5:1, voire entre 0,7:1 et 1,3:1, de préférence égal à 1:1 ; ou
- un mélange de chlorure de choline et d'au moins un composé HBD choisi parmi l'acide formique, l'urée et leur mélange, dans un rapport molaire chlorure de choline : HBD compris entre 0,2:2 et 5:2, notamment entre 0,5:2 et 1,5:2, voire entre 0,7:2 et 1,3:2, de préférence égal à 1:2 ;
de préférence le DES comprenant, voire consistant en, un mélange de chlorure de choline et d'urée dans un rapport molaire chlorure de choline : urée compris entre 0,2:2 et 5:2, notamment entre 0,5:2 et 1,5:2, voire entre 0,7:2 et 1,3:2, de préférence égal à 1:2.

8. Procédé selon l'une quelconque des revendications 1 à 6, le DES étant hydrophobe, en particulier comprenant, voire consistant en :
- au moins un composé HBA choisi parmi les monoterpénoïdes comportant au moins un groupe fonctionnel oxygéné et leurs mélanges, et
- au moins un composé HBD choisi parmi les acides monocarboxyliques aliphatiques non substitués, saturés ou insaturés, linéaires ou ramifiés, possédant de 6 à 20 atomes de carbone, l'acide lactique, l'acide 3-phenylpropionique, les acides dicarboxyliques hydrocarbonés non aromatiques, non substitués, saturés, linéaires ou ramifiés, possédant de 7 à 10 atomes de carbone, l'acide téréphtalique, la vanilline, la lidocaïne, le méthoxybenzène, l'eau, les composés de formule HR^{a}N-C(=X)-R^{d} (I), avec X étant choisi parmi un atome d'oxygène et un atome de soufre, R^{a} étant choisi parmi un atome d'hydrogène et un radical alkyle, linéaire ou ramifié, en C₁ à C₄, et R^{d} étant choisi parmi un radical alkyle, linéaire ou ramifié, en C₁ à C₄ et un radical -NR^{b}R^{c} avec R^{b} et R^{c} étant indépendamment l'un de l'autre choisis parmi un atome d'hydrogène et un radical alkyle, linéaire ou ramifié, en C₁ à C₄, et leurs mélanges ; plus particulièrement comprenant, voire consistant en :
- un mélange d'un composé HBA choisi parmi les monoterpénoïdes comportant au moins un groupe hydroxyle, les monoterpénoïdes comportant au moins un groupe carbonyle, et leurs mélanges et d'un composé HBD choisi parmi les acides monocarboxyliques aliphatiques saturés non substitués, linéaires ou ramifiés, possédant de 6 à 18 atomes de carbone, l'acide lactique, l'acide 3-phenylpropionique, l'acide téréphtalique, la vanilline, la lidocaïne, le méthoxybenzène, et leurs mélanges, dans un rapport molaire HBA : HBD compris entre 0,2:1 et 5:1, notamment entre 0,5:1 et 1,5:1, voire entre 0,7:1 et 1,3:1, de préférence égal à 1:1 ;
- un mélange d'un composé HBA choisi parmi les monoterpénoïdes comportant au moins un groupe hydroxyle, les monoterpénoïdes comportant au moins un groupe carbonyle, et leurs mélanges et d'un composé HBD choisi parmi l'acide décanoïque, l'acide lactique, l'acide azélaïque, l'acide téréphtalique et leurs mélanges, dans un rapport molaire HBA : HBD compris entre 1:1 et 4:1, notamment entre 1,5:1 et 2,5:1, voire entre 1,7:1 et 2,3:1, de préférence égal à 2:1 ;
- un mélange d'un composé HBA choisi parmi les monoterpénoïdes comportant au moins un groupe hydroxyle, les monoterpénoïdes comportant au moins un groupe carbonyle, et leurs mélanges et d'acide décanoïque, dans un rapport molaire HBA : acide décanoïque compris entre 2:1 et 4:1, notamment entre 2,5:1 et 3,5:1, voire entre 2,7:1 et 3,3:1, de préférence égal à 3:1 ;
- un mélange d'un composé HBA choisi parmi les monoterpénoïdes comportant au moins un groupe hydroxyle, les monoterpénoïdes comportant au moins un groupe carbonyle, et leurs mélanges et d'un composé HBD choisi parmi l'acide décanoïque, l'acide lactique, l'acide téréphtalique, l'urée et leurs mélanges, dans un rapport molaire HBA : HBD compris entre 2:1 et 10:1, notamment entre 4:1 et 6:1, voire entre 4,5:1 et 5,5:1, de préférence égal à 5:1 ;
- un mélange d'un composé HBA choisi parmi les monoterpénoïdes comportant au moins un groupe hydroxyle, les monoterpénoïdes comportant au moins un groupe carbonyle, et leurs mélanges et d'eau, dans un rapport molaire HBA : eau compris entre 2:1 et 10:1, notamment entre 4:1 et 6:1, voire entre 4,3:1 et 5,3:1, de préférence égal à 4,8:1 ; ou
- un mélange d'un composé HBA choisi parmi les monoterpénoïdes comportant au moins un groupe hydroxyle, les monoterpénoïdes comportant au moins un groupe carbonyle, et leurs mélanges et d'acide lactique, dans un rapport molaire HBA : acide lactique compris entre 7:1 et 13: 1, notamment entre 9:1 et 11:1, voire entre 9,5:1 et 10,5:1, de préférence égal à 10:1 ;
notamment comprenant, voire consistant en :
- un mélange de thymol et d'un composé HBD choisi parmi l'acide hexanoïque, l'acide heptanoïque, l'acide octanoïque, l'acide décanoïque, l'acide dodécanoïque, l'acide lactique, l'acide 3-phenylpropionique, l'acide téréphtalique, la vanilline, la lidocaïne, le méthoxybenzène, et leurs mélanges, dans un rapport molaire thymol : HBD compris entre 0,2:1 et 5:1, notamment entre 0,5:1 et 1,5:1, voire entre 0,7:1 et 1,3:1, de préférence égal à 1:1 ;
- un mélange de thymol et d'un composé HBD choisi parmi l'acide décanoïque, l'acide lactique, l'acide azélaïque, l'acide téréphtalique et leurs mélanges, dans un rapport molaire thymol : HBD compris entre 1:1 et 4:1, notamment entre 1,5:1 et 2,5:1, voire entre 1,7:1 et 2,3:1, de préférence égal à 2:1 ;
- un mélange de thymol et d'acide décanoïque, dans un rapport molaire thymol : acide décanoïque compris entre 2:1 et 4:1, notamment entre 2,5:1 et 3,5:1, voire entre 2,7:1 et 3,3:1, de préférence égal à 3:1 ;
- un mélange de thymol et d'un composé HBD choisi parmi l'acide décanoïque, l'acide lactique, l'acide téréphtalique, l'urée et leurs mélanges, dans un rapport molaire thymol : HBD compris entre 2:1 et 10:1, notamment entre 4:1 et 6:1, voire entre 4,5:1 et 5,5:1, de préférence égal à 5:1 ;
- un mélange de thymol et d'eau, dans un rapport molaire thymol : eau compris entre 2:1 et 10:1, notamment entre 4:1 et 6:1, voire entre 4,3:1 et 5,3:1, de préférence égal à 4,8:1 ; ou
- un mélange de thymol et d'acide lactique, dans un rapport molaire thymol : acide lactique compris entre 7:1 et 13:1, notamment entre 9:1 et 11:1, voire entre 9,5:1 et 10,5:1, de préférence égal à 10:1 ;
de préférence, comprenant, voire consistant en :
- un mélange de thymol et d'acide décanoïque, dans un rapport molaire thymol : acide décanoïque compris entre 0,2:1 et 5:1, notamment entre 0,5:1 et 1,5:1, voire entre 0,7:1 et 1,3:1, de préférence égal à 1:1 ;
- un mélange de thymol et d'acide lactique, dans un rapport molaire thymol : acide lactique compris entre 1:1 et 4:1, notamment entre 1,5:1 et 2,5:1, voire entre 1,7:1 et 2,3:1, de préférence égal à 2:1 ; ou
- un mélange de thymol et d'eau, dans un rapport molaire thymol : eau compris entre 2:1 et 10:1, notamment entre 4:1 et 6:1, voire entre 4,3:1 et 5,3:1, de préférence égal à 4,8:1 ; plus particulièrement, comprenant, voire consistant en :
- un mélange de thymol et d'acide décanoïque, dans un rapport molaire thymol : acide décanoïque compris entre 0,2:1 et 5:1, notamment entre 0,5:1 et 1,5:1, voire entre 0,7:1 et 1,3:1 de préférence égal à 1:1 ; ou
- un mélange de thymol et d'acide lactique, dans un rapport molaire thymol : acide lactique compris entre 1:1 et 4:1, notamment entre 1,5:1 et 2,5:1, voire entre 1,7:1 et 2,3:1, de préférence égal à 2:1.

9. Procédé selon l'une quelconque des revendications précédentes, l'étape b) étant réalisée à une température supérieure ou égale à la température de fusion du DES, en particulier à une température d'au moins 70°C, notamment allant de 100°C à 200°C, voire de 130°C à 190°C, avec un DES hydrophile ou à une température allant de 10°C à 100°C, notamment de 60°C à 70°C, avec un DES hydrophobe.

10. Procédé selon l'une quelconque des revendications précédentes, l'étape b) étant réalisée pendant au moins 10 min, en particulier pendant 10 min à 10h, plus particulièrement pendant 30 min à 5h, voire pendant 1h à 4h.

11. Procédé selon l'une quelconque des revendications précédentes, la feuille arrière étant mise en œuvre à l'étape b) à raison de 30 à 50% massique, en particulier de 30% à 40% massique par rapport à la masse totale de DES.

12. Procédé selon l'une quelconque des revendications précédentes, comprenant préalablement à l'étape a) la récupération de la feuille arrière par désassemblage d'un module photovoltaïque, en particulier usagé ou défectueux.

13. Procédé selon l'une quelconque des revendications précédentes, comprenant en outre à l'issue de l'étape b) la récupération de chacune des couches constitutives de la feuille arrière sous une forme désolidarisée les unes des autres.

14. Procédé selon l'une quelconque des revendications précédentes, comprenant en outre le rinçage, notamment par mise en contact avec de l'eau et/ou de l'éthanol, des couches récupérées à l'issue de l'étape b), les couches étant en particulier séchées après rinçage, notamment à une température allant de 10°C à 100°C voire de 20°C à 50°C.

15. Utilisation du procédé de délamination selon l'une quelconque des revendications précédentes pour le recyclage des matériaux constitutifs d'une feuille arrière multicouche de module photovoltaïque, notamment telle que définie dans l'une quelconque des revendications 1 à 4.
